# FASCICULE DE BREVET EUROPEEN

(11) **EP 3 080 782 B1**
(45) Date de publication et mention de la délivrance du brevet: **11.03.2026**
(21) Numéro de dépôt: 14869145.4
(22) Date de dépôt: 12.12.2014
(51) Int. Cl.: G06T 19/00, G06T 7/30, G06T 7/66, G06T 19/20, G06F 16/532, G06F 16/583, G06F 30/00

(54) **MÉTHODE ET SYSTÈME DE COMPARAISON DE MODÈLES 3D**
VERFAHREN UND SYSTEM ZUM VERGLEICHEN VON 3D-MODELLEN
METHOD AND SYSTEM FOR COMPARING 3D MODELS

(30) Priorité: 15.12.2013 US 201361916279 P
(43) Date de publication de la demande: 19.10.2016
(73) Titulaire: Socovar Societe En Commandite, Montreal, Quebec H3A 1B9 (CA)
(72) Inventeur: MARANZANA, Roland, Montréal, Québec H8R 2N9 (CA); MSAAF, Omar, Montréal, Québec H3J 1T6 (CA); RIVEST, Louis, Montréal, Québec H2C 2S7 (CA)
(74) Mandataire: IPAZ
(86) Numéro de dépôt international: PCT/CA2014/051210
(87) Numéro de publication internationale: WO 2015/085435

(56) Documents cités:
- EP-A1- 2 284 770
- WO-A1-2013/044484
- JP-A- 2012 043 419
- US-A1- 2009 040 225
- US-B1- 6 625 607
- KOLONIAS I ET AL: "Fast Content-Based Search of VRML Models Based on Shape Descriptors", IEEE TRANSACTIONS ON MULTIMEDIA, IEEE SERVICE CENTER, PISCATAWAY, NJ, US, vol. 7, no. 1, 1 February 2005 (2005-02-01), pages 114 - 126, XP011125468, ISSN: 1520-9210, DOI: 10.1109/TMM.2004.840605

## Description

La présente demande revendique la priorité de la demande de brevet provisoire des États-Unis 61/916,279, déposée le 15 décembre 2013.

### Domaine technique

Cette demande de brevet a trait au domaine des modèles 3D, par exemple les représentations numériques dans un espace de dimension 3, et plus précisément au domaine de la comparaison de modèles 3D, notamment par le biais de descripteurs, pour les fins d'une recherche, d'un classement et/ou d'une analyse comparative des parties.

### Technique antérieure

Les représentations numériques en 3 dimensions d'objets sont d'emploi courant dans les mondes de l'ingénierie, du médicale, du jeu vidéo, du cinéma, et même dans les applications de masse (mentionnons SketchUp par Google, aujourd'hui Trimble). Cet usage est possible notamment grâce aux logiciels de création et d'édition 3D dont les systèmes de CAO (*conception assistée par ordinateur*), à l'ingénierie inverse et à d'autres techniques de reconstruction 3D, mais grâce également aux équipements de numérisation 3D. Tous ces moyens génèrent des modèles numériques de dimension 3. D'aucuns constituent des modèles 3D qui décrivent les limites entre les objets et leur environnement et que l'on appelle des *représentations par les frontières* (en anglais *boundary representation* ou *B-rep,* que l'on rencontre par exemple dans la norme STEP ou dans des modeleurs géométriques comme Parasolid ou Acis). D'autres y vont d'une *facettisation* ou d'une *tessellation* (comme les formats STL ou VRML, par exemple). Ces modèles peuvent inclure des informations autres que purement géométriques.

Les types de modèles 3D susmentionnés sont d'ailleurs très répandus dans les entreprises et dans de nombreux secteurs de la vie courante, et leur nombre déjà élevé augmente rapidement. Par conséquent, un problème combiné se pose, soit (i) de répertorier les modèles 3D, (ii) de retrouver des objets numériques similaires, (iii) de les comparer afin d'en identifier les différences ou les parties identiques, et enfin (iv) d'afficher les résultats pertinents pour assurer une exploitation simple et efficace en fonction de critères définis.

Il existe aujourd'hui deux catégories distinctes de systèmes pour d'une part comparer un modèle 3D de référence à un second modèle 3D pour déterminer les différences entre eux et d'autre part rechercher des modèles 3D qui ressemblent à un modèle 3D donné en référence.

### Les systèmes ou outils de comparaisons de modèles 3D

Plusieurs applications informatiques, dont les systèmes de CAO, proposent des méthodes pour comparer entre eux de manière précise deux modèles 3D ou encore un modèle 3D avec un nuage de points ou un modèle 3D reconstruit à partir d'un objet réel. Dans cette approche, deux modèles 3D sont d'abord sélectionnés. On peut choisir parmi plusieurs différentes méthodes pour comparer ces deux modèles. On peut faire appel à la comparaison des structures topologiques et géométriques avec des approches de types graphes (Graph mapping, comme par exemple WO 2007/098929 A1), ou encore faire appel à une méthode basée sur des points (comme par exemple US 7,149,677 B2, ou par la méthode des moindres carrés comme dans le produit d'Innovmetric ou US 8,072,450 B2). Certaines méthodes exigent que les deux modèles soient dans le même référentiel, dans la même application informatique (même système CAO, par exemple), et utilisent la même représentation géométrique. Les méthodes fondées sur une comparaison aux niveaux géométriques et topologiques exigent impérativement que les deux modèles 3D comparés respectent ces conditions. Tout dépendamment de la méthode de comparaison utilisée, le marquage des modèles 3D distingue les parties identiques et les parties différentes des deux modèles 3D en leur associant par exemple un état (identiques, modifiées, uniques) ou encore en quantifiant les différences entre les deux modèles 3D (une distance entre des points des modèles A et B respectivement, par exemple). Le résultat de la comparaison des deux modèles 3D est ensuite affiché, soit (i) en superposant les deux modèles 3D, (ii) en appliquant une gradation de couleur pour mettre en évidence la différence entre les modèles A et B ou des champs de vecteurs, ou encore (iii) un code de couleur en fonction de l'état défini au module précédent. Cette comparaison indique les parties du modèle 3D (les faces) identiques, les parties uniques (faces non appariées) ou modifiées (faces appariées présentant une différence), et éventuellement les parties ajoutées sur un modèle par rapport à l'autre (d'où l'affichage symétrique pour voir ce qui existe sur A par rapport à B et ce qui existe sur B par rapport à A). Bien que tous ces systèmes soient différents, ils se rejoignent tous sur un point : lorsqu'ils comparent le modèle 3D de référence avec le modèle 3D cible, ils choisissent un référentiel unique ou un « best fit » unique duquel ils compareront les modèles 3D complets pour montrer les différences.

L'application de Geometric Ltd inclue dans SolidWorks est un exemple typique et représentatif de cette catégorie.

### Les systèmes ou outils de recherche de modèles 3D

Une deuxième catégorie d'applications propose de rechercher des modèles 3D en comparant un modèle 3D de référence avec un ensemble de modèles 3D dans le but de sélectionner les modèles 3D en fonction de leur ressemblance avec le modèle 3D de référence. Cette ressemblance est habituellement exprimée par une valeur quantitative utilisée pour ordonner les modèles 3D. Diverses méthodes sont proposées pour déterminer cette ressemblance. Dans un premier temps, chaque modèle 3D est analysé en vue de produire une représentation plus efficace pour réaliser les comparaisons par la suite. En l'espèce, cette représentation est souvent désignée sous divers termes, notamment descripteur, représentation, et index. Quelle que soit son appellation, cette représentation peut avoir plusieurs formes, tel un graphe (US 2004/0249809 A1), un vecteur de dimension N fixe (US 6,625,607 B1) ou variable en fonction du modèle 3D, etc. Ces descripteurs sont généralement sauvegardés pour être utilisés au moment où les comparaisons sont effectuées. Un modèle 3D est choisi pour servir de référence. Dans certains cas, le modèle 3D de référence est remplacé par des images, des photographies ou des dessins en deux dimensions [A 3D Model Search Engine, Patrick Min, Ph.D. Dissertation, Princeton University, 2004]. Si nécessaire, son descripteur est calculé. Les descripteurs sont comparés. Ici encore plusieurs méthodes sont décrites dans [Content-based Three-dimensional Engineering Shape Search, K. Lou, S. Prabhakar, K. Ramani, Proceedings of the 20th International Conference on Data Engineering 2004]. En fonction des résultats de la comparaison, les modèles 3D similaires sont généralement ordonnés en fonction d'une grandeur, que nous appelons indice de similarité ou de ressemblance. Ces résultats sont ensuite affichés sous différentes formes, habituellement des images de petites tailles (icônes, miniatures). Le brevet US 6625607 B1 et l'article "Fast Content-Based Search of VRML Models Based on Shape Descriptors" de KOLONIAS I ET AL, ISSN: 1520-9210, DOI: 10.1109/TMM.2004.840605 divulguent deux autres méthodes connues de l'art antérieur.

Tel que mentionné précédemment, de nombreuses approches ont été proposées pour rechercher des modèles 3D par rapport à la forme d'un modèle de référence. Certaines approches visent les formes de type organique, d'autres visent une similarité permissive (ex. retrouver des voitures, des chaises, des verres). En particulier, ces méthodes ne sont pas conçues pour déterminer si deux modèles 3D sont exactement les mêmes, avec des précisions du même ordre de grandeur que les tolérances de fabrication. Des systèmes comme par exemple Geolus de Siemens ou GeoSearch de Cadenas sont représentatives de cette catégorie. Ils analysent des modèles 3D approximés par des représentations à facettes planes pour générer leurs descripteurs détériorant donc obligatoirement leur précision. Plusieurs méthodes proposées pour extraire les descripteurs des modèles 3D et pour comparer ces descripteurs entre eux, nécessitent un temps de calcul élevé et sont donc difficilement applicables lorsque le nombre de modèles 3D à traiter est important (plus d'un million de modèles, par exemple) ou pour une recherche interactive.

Or, les systèmes ou outils de recherche de modèles 3D connus ne possèdent ni les informations ni les technologies pour offrir la capacité de lancer une recherche basée sur la prise en compte des modèles 3D complets qui privilégient des parties de ces modèles 3D.

### Sommaire de l'invention

Il existe des besoins pour des systèmes qui retrouvent des modèles numériques 3D de sources hétérogènes qui se ressemblent en tout ou en partie, qui déterminent et qualifient les différences par rapport à un modèle 3D de référence considéré dans son ensemble ou en partie, qui affichent les résultats avec toute l'information pertinente sur les différences et les ressemblances, le tout de manière extrêmement précise suivant différents critères et qui soient adaptés pour traiter de très grandes quantités de modèles 3D .

Pour répondre à ces besoins, nous proposons un processus qui dans un premier temps, construit des descripteurs pour repérer (ou indexer) les modèles 3D. Ce descripteur se distingue par sa capacité à capturer des propriétés au niveau d'un modèle 3D complet, de chaque corps solide (au sens habituel de la représentation géométrique et topologique tridimensionnelle) composant éventuellement un modèle 3D et aussi des propriétés au niveau de chaque face (toujours au sens habituel de la représentation géométrique et topologique tridimensionnelle) composant le modèle 3D. Les représentations par les frontières ne garantissent pas l'unicité de représentation d'un modèle 3D, c'est-à-dire que plusieurs représentations par les frontières pourraient correspondre au même objet. Pour obtenir cette propriété essentielle à la comparaison des modèles 3D, nous regroupons les faces qui sont continues G2 (dérivée seconde géométrique) tout le long d'une de leur arête commune et nous scindons le long de la discontinuité les faces construit sur une surface qui ne serait pas continue G2. Tous les traitements subséquents du processus, sauf l'affichage en 3D, sont possibles sur les descripteurs sans avoir à recourir nécessairement aux modèles 3D.

Dans la suite du processus proposé, les caractéristiques des descripteurs sont comparées en fonction de critères sélectionnés par l'opérateur. Cette phase repose sur deux éléments essentiels de l'invention. L'un d'entre eux est la réconciliation des termes ou caractéristiques des descripteurs, ce qui correspond à un appairage des corps solides et des faces des modèles 3D qui peuvent, de ce fait, être exprimés dans des référentiels différents, des systèmes CAO différents, des représentations géométriques et topologiques différentes ce qui autorise la prise en compte d'une partie seulement des modèles 3D pour le traitement. L'autre élément est la qualification plus rigoureuse des différences au niveau des faces, par rapport aux méthodes actuelles que se limitent à identique, modifiée ou nouvelle. Nous introduisons jusqu'à neuf qualités (identique, intrinsèquement identique, type géométrique identique, topologie différente, etc.) ; une face peut porter plusieurs qualités simultanément. Le marquage pour l'affichage s'appuie sur ces propriétés (par exemple une couleur associée à une combinaison de qualités) et les critères de la requête de l'opérateur. L'agrégation de toutes les différences détermine l'indice de ressemblance (ou de similarité) qui ordonne les modèles 3D.

Comme les objets numériques manipulés sont des modèles 3D, nous proposons une nouvelle manière de communiquer les résultats sous la forme d'une structure 3D dans un espace 3D unique. L'un des axes représente l'indice de ressemblance, les couleurs des faces sont utilisées pour marquer les types de différence et les deux axes restants sont par exemple utilisés pour représenter d'autres grandeurs ou propriétés comme par exemple, des coûts, des dates, des fournisseurs, des configurations, des versions, etc.

Ce processus sert par exemple, (i) à repérer des modèles 3D identiques à un modèle 3D de référence avec une précision comparable à celle de leur fabrication (repérage de doublons ou clones géométriques); (ii) à repérer une pièce (un corps solide) identique ou similaire dans un ou plusieurs systèmes mécaniques (un modèle 3D); (iii) à repérer un composant (ensemble de corps solides) identiques ou similaires dans un système ou plusieurs systèmes (des modèles 3D); (iv) à repérer des modèles 3D semblables dans de larges banques de modèles éventuellement distribués; etc.

Grâce aux descripteurs qui capturent des propriétés avec une granularité très fine (ensemble de paramètres ou caractéristiques au niveau de chaque face) et aux capacités du comparateur, notamment le principe de réconciliation et la qualification des faces, le système fonctionne également au niveau du repérage de caractéristiques de formes (form features), c'est-à-dire des parties des modèles 3D comme par exemple pour repérer (i) un ensemble de perçages débouchants de diamètre et d'entre-axes donnés (ensemble de faces disjointes et leurs paramètres) dans divers modèles 3D; (ii) une rainure de clavette (ensemble de faces adjacentes et paramètres intrinsèques); (iii) à repérer une face ou un ensemble de faces identiques ou similaires dans un ou plusieurs modèles 3D; etc.

Chaque partie, soit (i) la méthode de recherche de modèle 3D semblables basée sur les descripteurs volumiques et de frontières, (ii) la réconciliation des termes ou caractéristiques des descripteurs autorisant le multi repositionnement et le repérage de sous parties du modèle 3D (caractéristiques de formes) , (iii) le principe de qualification des différences et (iv) l'affichage de résultats combinant similarités et différences entre plusieurs modèles 3D dans un espace unique de dimension 3, sont des aspects pertinents de l'invention. L'invention est définie par les revendications indépendantes 1 et 10. Le revendications dépendantes définissent des modes de réalisations supplémentaires.

Selon un premier aspect, on propose un procédé de comparaison des modèles 3D aux fins d'une recherche, d'un classement et/ou d'une analyse comparative des représentations par les frontières des modèles 3D. Selon ce procédé, on fournit un descripteur à chacun d'une pluralité de modèles 3D, les descripteurs comprenant des caractéristiques géométriques des modèles 3D qui sont invariables en fonction du repère de modélisation et des caractéristiques géométriques des modèles 3D qui dépendent du repère. On utilise des caractéristiques qui sont invariables en fonction du repère pour apparier les parties d'un premier modèle 3D et les parties d'au moins un autre modèle 3D. On utilise des caractéristiques qui dépendent du repère pour au moins les parties dont l'appariement est réussi pour déterminer un groupe de transformations associant les parties entre le premier modèle 3D et les parties d'au moins un autre modèle 3D. On détermine au moins un groupe de transformations identiques, où les ressemblances et les différences entre modèles 3D sont identifiées, au moins en partie, par ledit groupe de transformations assimilables.

Les caractéristiques géométriques des parties de modèle 3D qui sont invariables en fonction du repère de modèle 3D peuvent comprendre l'aire, les valeurs propres des moments d'inertie et/ou le périmètre des faces planes de modèle 3D, et des caractéristiques géométriques des parties de modèle 3D qui dépendent du repère de modèle 3D comprennent le centre de gravité et/ou les axes des moments d'inertie des faces planes.

L'étape de déterminer au moins un groupe de transformations identiques peut comprendre déterminer au moins deux groupes de transformations identiques afin de permettre la comparaison des modèles 3D similaires mais où au moins une partie des modèles 3D est dans une position et/ou orientation différente.

Selon un deuxième aspect, on propose un procédé de comparaison de modèles 3D aux fins d'une recherche, d'un classement, et/ou d'une analyse comparative des représentations par les frontières des modèles 3D. Selon ce procédé, on fournit un descripteur à chacun d'une pluralité de modèles 3D, les descripteurs comprenant des caractéristiques géométriques des modèles 3D qui sont invariables en fonction du repère de modélisation et des caractéristiques géométriques des modèles 3D qui dépendent du repère. On utilise des caractéristiques qui sont invariables en fonction du repère pour apparier les faces d'un premier modèle 3D et d'au moins un autre modèle 3D. On stocke des données classées selon les similarités déterminées et les différences déterminées entre les caractéristiques associées aux descripteurs dudit au moins un autre modèle 3D. Pour au moins les faces dont l'appariement est réussi, on détermine une transformation associant les faces entre les cadres de référence du premier modèle 3D. Et on rend un ou plusieurs dudit au moins un autre modèle 3D dont au moins les caractéristiques sont codées par couleur ou par texture en fonction des données représentant les similarités et les propriétés des différences.

Les caractéristiques géométriques des éléments de modèle 3D qui sont invariables en fonction du repère de modélisation peuvent comprendre l'aire, les valeurs propres des moments d'inertie et/ou le périmètre des faces planes de modèle 3D, et des caractéristiques géométriques des éléments de modèle 3D qui dépendent du repère de modélisation comprennent le centre de gravité et/ou les axes des moments d'inertie des faces planes.

Selon un troisième aspect, on propose un procédé de comparaison de modèles 3D aux fins d'une recherche, d'un classement, et/ou d'une analyse comparative des représentations par les frontières des modèles 3D. Selon ce procédé, on fournit un descripteur à chacun d'une pluralité de modèles 3D, les descripteurs comprenant des caractéristiques géométriques des modèles 3D qui sont invariables en fonction du repère de modélisation et des caractéristiques géométriques des modèles qui dépendent du repère. On utilise des caractéristiques qui sont invariables en fonction du repère pour apparier les faces d'un premier modèle 3D et d'au moins un autre modèle 3D. On stocke la première collecte de données afférente à l'appariement pour au moins certains autres modèles 3D. On fournit un premier résultat de recherche, de classement, et/ou de comparaison des représentations par les frontières des modèles 3D en utilisant au moins en partie les données initiales relatives à l'appariement. On continue d'utiliser des caractéristiques qui sont invariables en fonction du repère pour apparier les faces entre le premier modèle 3D et dudit au moins un autre modèle 3D pour bâtir sur ces données initiales relatives à l'appariement. Et, on fournit un deuxième résultat de recherche, de classement, et/ou d'une comparaison des représentations par les frontières en utilisant au moins en partie les données raffinées relatives à l'appariement.

Selon un quatrième aspect, on propose un procédé de comparaison des modèles 3D aux fins d'une recherche, d'un classement et/ou d'une analyse comparative des représentations par les frontières des modèles 3D . Selon ce procédé, on fournit un descripteur à chacun d'une pluralité de modèles 3D, les descripteurs comprenant des caractéristiques des modèles 3D. On attribue une importance accrue ou réduite à l'une ou plusieurs caractéristiques dans un premier modèle 3D. On génère une valeur d'appariement entre un premier modèle 3D et au moins un autre modèle 3D grâce aux caractéristiques et, lorsqu'il y a lieu, l'importance attribuée à l'une ou plusieurs de ces caractéristiques du premier modèle 3D.

Selon un cinquième aspect on propose un procédé de comparaison des modèles 3D aux fins d'une recherche, d'un classement et/ou d'une analyse comparative des représentations par les frontières des modèles 3D . Selon ce procédé, on fournit un descripteur à chacun d'une pluralité de modèles 3D. On génère une valeur d'appariement entre un premier modèle 3D et nombre d'autres modèles 3D en utilisant leurs descripteurs respectifs. Et, on génère un affichage de nombre de modèles 3D disposés spatialement en regroupements, où les regroupements sont chacun définis en fonction d'une caractéristique de descripteur commune. Les regroupements peuvent être en fonction d'un critère de recherche ou de l'importance accordée à l'une ou des caractéristiques des descripteurs ou d'une pondération de recherche.

Selon un sixième aspect, on propose un procédé de comparaison des modèles 3D aux fins d'une recherche, d'un classement et/ou d'une analyse comparative des représentations par les frontières des modèles 3D. Selon ce procédé, on fournit un descripteur à chacun d'une pluralité de modèles 3D en tenant compte des faces continues géométriquement d'ordre 2 communément dites « G2 », de préférence en les unifiant et en découpant les faces dont les surfaces ne seraient pas continues géométriquement d'ordre 2 (surface G2).

Selon un septième aspect, on propose un procédé de comparaison des modèles 3D aux fins d'une recherche, d'un classement et/ou d'une analyse comparative des représentations par les frontières des modèles 3D. Selon ce procédé, on sélectionne au moins deux parties correspondantes sur deux modèles 3D. On identifie les parties respectivement similaires et on qualifie les parties différentes par rapport à un ou plusieurs types de différences. On affiche au moins un des modèles 3D en marquant selon la qualification les parties identiques et différentes.

Selon certaines réalisations, un système de recherche de modèles 3D servant à repérer des modèles 3D parmi une collection de modèles 3D correspondant à un modèle 3D de requête de recherche par l'entremise de descripteurs des modèles 3D comprend un sélecteur de caractéristiques servant à sélectionner au moins une caractéristique ou une partie du modèle 3D de requête de recherche à laquelle on attribue une pondération différente pour les fins de la recherche, et un comparateur de modèles 3D, ledit comparateur configuré pour comparer un descripteur dudit modèle 3D de requête de recherche aux descripteurs de ladite collection de modèles 3D en tenant compte de ladite pondération dudit aspect caractéristique ou partie dudit modèle 3D de requête de recherche, et de produire une liste des modèles correspondants selon la comparaison.

Le sélecteur de caractéristiques peut attribuer des valeurs de pondération aux paramètres d'un descripteur dudit modèle 3D de requête de recherche. Le système peut comprendre en outre un classeur des résultats de recherche et un générateur d'image configuré de telle manière à générer une image affichable d'au moins une partie de la liste des modèles 3D correspondants, disposés et organisés selon des critères présélectionnés. Lesdits modèles 3D correspondants peuvent être disposés en fonction d'un indice de similarité calculé à partir des descripteurs. Lesdits critères présélectionnés peuvent inclure un critère lequel dépend du descripteur, caractérisé en ce que lesdits modèles 3D correspondants sont classés selon des caractéristiques lesquels dépendent du descripteur. Le sélecteur de caractéristiques peut être configuré de manière à reconnaitre les aspects caractérisants des descripteurs du classeur des résultats et à sélectionner l'un des aspects caractérisants des descripteurs. Les descripteurs peuvent inclure une composante volumétrique et une face et/ou une composante arête.

Selon certaines réalisations, un système de recherche de modèles 3D servant à identifier des modèles 3D dans une collection de modèles 3D correspondant à un modèle 3D de requête de recherche à partir de descripteurs des modèles 3D comprend un sélecteur pour sélectionner un modèle de requête 3D, un comparateur de modèles 3D configuré de manière à comparer le descripteur du modèle 3D de requête avec des descripteurs de la collection des modèles 3D et de fournir une liste de modèles 3D correspondants, et un classeur des résultats de recherche et un générateur d'images configuré de telle façon à générer une image affichable d'au moins une portion de la liste des modèles 3D correspondants, disposés et organisés selon des critères présélectionnés.

Les modèles 3D correspondants peuvent être disposés en fonction d'un indice de similarité calculé à partir des descripteurs. Les critères présélectionnés peuvent inclure un critère lequel dépend du descripteur, caractérisé en ce que lesdits modèles 3D correspondants sont classés selon des caractéristiques lesquels qui dépendent du descripteur. L'image générée peut présenter des modèles organisés en plusieurs colonnes ou rangées selon leurs caractéristiques similaires.

Selon certaines réalisations, le procédé de fabrication d'un produit est caractérisé par l'exploitation d'un modèle 3D pour la fabrication d'au moins une pièce du produit, ledit modèle 3D étant directement sélectionné et éventuellement modifié en se servant d'un système de recherche/comparaison de modèles 3D ou du procédé selon l'une ou l'autre des réalisations selon la présente invention.

Le lecteur doit comprendre que la présente description expose éventuellement plusieurs inventions, et la référence dans cette demande à l'invention peut vouloir dire l'une ou l'autre de ces inventions.

### Définitions

Dans cette demande de brevet, les termes suivants auront la signification suivante :

### modèle 3D

Dans ce texte, nous utilisons l'expression modèle 3D pour désigner une représentation numérique dans un espace de dimension 3 d'un objet. Un modèle 3D décrit les limites entre un ou une pluralité d'objets et leur environnement. Les modèles 3D sont communément basés sur les représentations par les frontières (en anglais boundary representation ou B-rep) comme dans la norme STEP ou les modeleurs géométriques des systèmes de CAO ou FAO par exemple ou les facettisations (tessellation en anglais) comme dans les formats STL ou VRML, par exemple. La frontière est composée d'une ou plusieurs faces, laquelle est une surface limitée par un ou plusieurs contours. Une face, une pluralité de faces (jointives ou non), ou encore un ensemble de faces représentant un sous espace euclidien de dimension 3 fermé (appelé généralement corps solide), sont tous des exemples de modèles 3D. Un ensemble de faces représentant une pluralité de corps solides est également un modèle 3D. Dans cette définition, toute partie d'un modèle 3D est un modèle 3D et toute composition de modèles 3D est un modèle 3D. Des modèles 3D peuvent inclure des informations autres que purement géométriques, telles que les propriétés des matériaux utilisés ou les techniques de fabrication préconisées.

### descripteur

Représentation d'un modèle 3D adaptée pour un usage spécifique, normalement exprimée de manière plus efficace et concise que le modèle 3D lui-même. C'est un ensemble d'informations qui caractérisent un modèle 3D ou une partie de celui-ci. Dans certains cas, le descripteur peut comprendre une liste de caractéristiques de géométrie volumétrique d'un modèle 3D, dont notamment les dimensions de la boite englobante du modèle 3D, son volume, son aire, les moments d'inertie principaux, son barycentre, ses axes d'inertie principaux, une liste de corps solides du modèle 3D dont pour chacun d'entre eux - et lequel forme aussi un modèle 3D - le volume, l'aire totale, les moments d'inertie principaux, le barycentre et les axes principaux d'inertie.

Dans certains cas, un descripteur peut comprendre notamment une liste de faces du modèle 3D et, pour chacune d'elles, une liste de caractéristiques dont le type de la surface sous-jacente et ses paramètres, les dimensions de la boite englobante, l'aire, le périmètre, les moments d'inertie principaux, le barycentre, les axes principaux d'inertie à titre d'exemple. Les différences et ressemblances entre modèles 3D sont obtenues à partir d'un processus que l'on nomme la comparaison des descripteurs. Dans son expression allégée et minimaliste, un modèle 3D peut être un descripteur à part entière. De même, un modèle 3D d'un objet plus complexe peut lui-même avoir plusieurs descripteurs différents, soit en se composant de plusieurs descripteurs (dont chacun pourrait à un modèle 3D dit constitutif), ou encore en tenant compte seulement de certaines informations et non pas d'autres qui caractérisent l'objet même.

### caractéristiques de forme

Une partie ou une propriété (ou un attribut) d'un descripteur (et donc d'un modèle 3D) présentant un intérêt particulier pour un traitement donné. Un élément du descripteur ou toute combinaison d'une pluralité d'éléments du descripteur définit une caractéristique de forme. Par exemple, la valeur du diamètre d'une face cylindrique est une caractéristique de forme élémentaire, la valeur d'un entre-axe de deux perçages est une caractéristique de forme, et une rainure de clavette à bout rond est une caractéristique de forme. À chacun de ces exemples correspond une partie d'un descripteur ou la caractéristique de forme peut être déterminée à partir des descripteurs. Dans sa forme la plus élémentaire, la caractéristique de forme est plus simplement appelée caractéristique. Une caractéristique est dite intrinsèque à un modèle 3D ou à son descripteur si elle ne dépend que du dit modèle 3D ou de son descripteur et peut être déterminée à partir de ce dernier et non du contexte, c'est-à-dire un modèle 3D qui engloberait la caractéristique. Dans le cas contraire, la caractéristique est dite extrinsèque.

### appariement

Processus de détermination de la correspondance entre des caractéristiques de deux descripteurs. Une partie d'un descripteur pourrait par exemple caractériser un corps solide ou une face. L'appariement consiste à faire correspondre à cette partie de descripteur, une autre partie d'un descripteur (le même ou un autre descripteur) lorsque les deux parties de descripteur partagent des caractéristiques communes (identiques ou compris dans des intervalles de valeurs par exemple). Ce processus permet entre autre d'apparier par l'intermédiaire de leurs descripteurs respectifs, les corps solides ou les faces de modèles 3D sans tenir compte de leur position dans l'espace. Ce processus d'appariement n'impose pas que les modèles 3D soient décrits avec la même représentation géométrique (STEP et Parasolid, par exemple) ni qu'ils soient exprimés dans un référentiel commun.

### réconciliation

Processus de regroupement de parties de descripteurs en prenant en compte la position relative dans l'espace des caractéristiques de formes associées à ces parties de descripteurs appariées. Le processus consiste à déterminer les groupes de matrices de transformation qui permettent de mettre dans un repère commun des caractéristiques de formes. Ce processus permet entre autre, de reconnaitre des caractéristiques de formes identiques ou similaires entre des modèles 3D. Ainsi au niveau des faces par exemple, l'appariement identifie des faces qui partagent des caractéristiques intrinsèques comme par exemple, les faces sont de type cylindrique, le diamètre est entre 5 et 6 mm, la longueur est de 20 mm. Lors de la réconciliation, des paramètres extrinsèques sont prises en compte comme par exemple, la direction de l'axe des faces cylindriques est égale à l'axe Z et les entre-axes sont de 20 mm. Ce processus appariement - réconciliation peut être appliqué de manière itérative.

### analyse comparative des descripteurs

Processus qui permet de rechercher, de déterminer, et de qualifier les caractéristiques identiques et différentes entre des descripteurs selon la requête spécifiée par l'opérateur. La comparaison est effectuée sur tout le descripteur ou seulement sur des parties du descripteur et une pondération différente spécifiée par l'opérateur peut être attribuée à chaque partie pour mettre l'emphase sur certaines caractéristiques de formes, voire à ne considérer qu'une partie du modèle 3D. L'indice de ressemblance (ou indice de similarité) est déterminé à partir de l'analyse comparative des descripteurs.

### opérateur

Désigne autant un opérateur humain qu'un autre système informatique, interagissant avec le système, en mode interactif ou hors ligne (batch mode).

### Brève description des dessins

Les réalisations de l'invention seront mieux comprises par le truchement de dessins, lesquels figurent plus loin et lesquels accompagnent nombre d'exemples apparaissant dans la description détaillée des réalisations de l'invention, parmi lesquelles :
La figure 1 présente un diagramme d'une séquence d'étapes d'un procédé selon une réalisation de l'invention;
La figure 2 présente un diagramme d'une séquence d'étapes d'un procédé selon une autre réalisation de l'invention;
La figure 3 présente un schéma-blocs d'un système informatique selon une réalisation configurée pour exécuter au moins le procédé selon la figure 1;
La figure 4 est une projection orthogonale de modèle 3D;
La figure 5 est une projection orthogonale d'une version simplifiée du modèle 3D de la figure 4;
La figure 6 est une projection orthogonale du modèle 3D de la figure 5 qui identifie de manière générique les faces des modèles 3D;
La figure 7A est une projection orthogonale du modèle 3D utilisé comme modèle 3D de référence dans la description de cette réalisation;
La figure 7B est une projection orthogonale d'un modèle 3D semblable à celui de la figure 7A servant à décrire le processus de comparaison;
La figure 8A est une projection orthogonale des modèles 3D des figures 7A et 7B suivant une première mise en position;
La figure 8B est une projection orthogonale des modèles 3D des figures 7A et 7B suivant une deuxième mise en position;
La figure 9 illustre une projection orthogonale du modèle 3D de référence et une interface permettant la définition de contraintes par l'opérateur montrant un ensemble de contraintes utilisé pour décrire une réalisation particulière;
La figure 10 est une projection orthogonale d'une pluralité de modèles 3D semblables positionnés et marqués selon le résultat de leur comparaison par rapport au modèle 3D de référence et les contraintes définies par l'opérateur;
La figure 11 présente un schéma-blocs d'une version du système informatique de la figure 3 suivant une architecture distribuée.

### Description détaillée des réalisations de l'invention

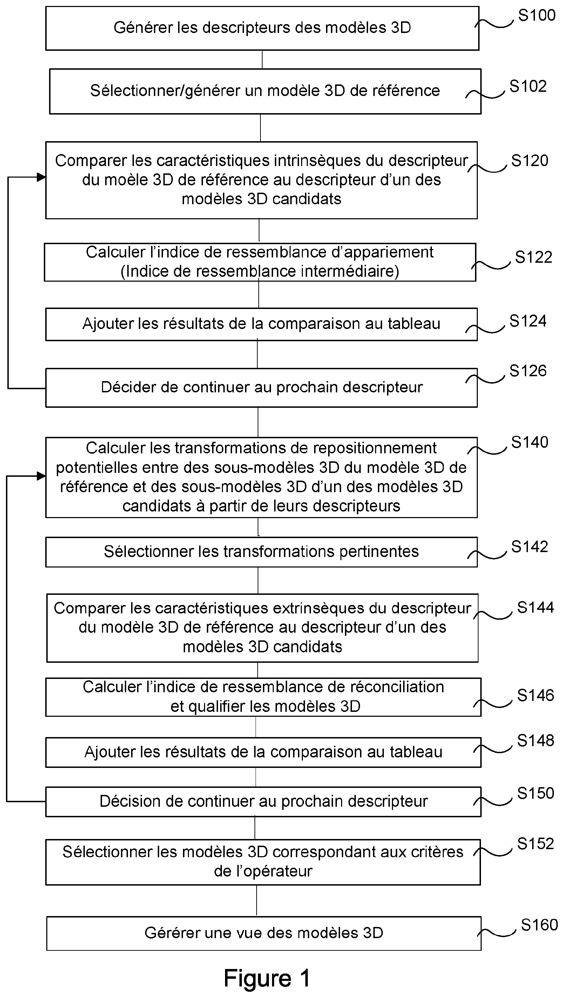

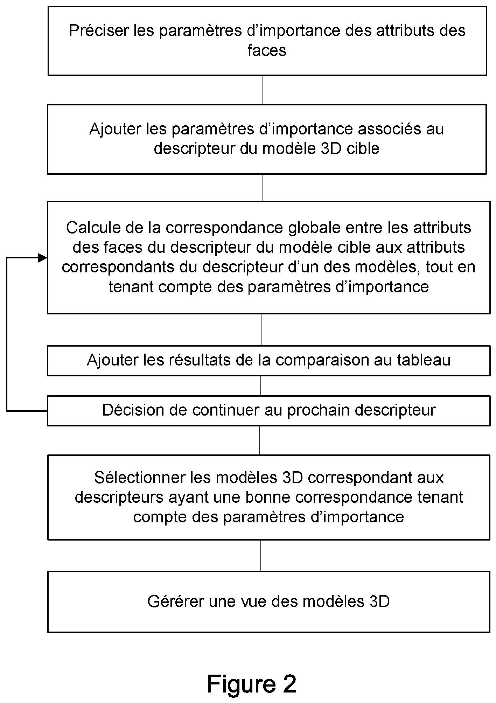

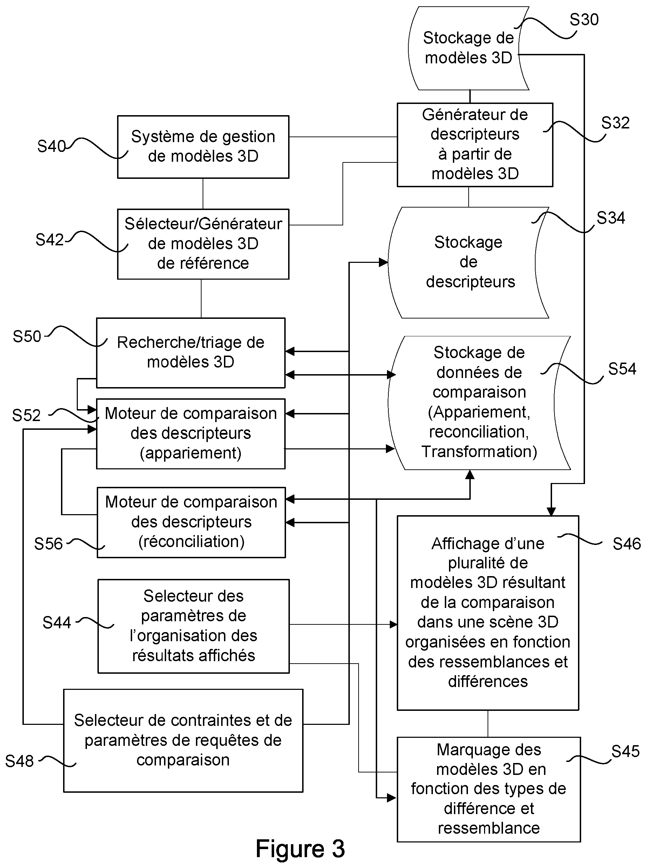

Les réalisations de l'invention sont décrites d'après les Figures 1 et 2, lesquelles montrent la séquence d'étapes à franchir pour déterminer de manière concomitante les ressemblances (ou les similarités) et les différences entre un modèle 3D de référence et un certain nombre de modèles 3D à partir de leurs descripteurs. Le nombre de modèles 3D pris en considération peut varier énormément. Dans la mesure où l'objectif consiste à comparer un modèle 3D de référence à quelques modèles 3D connus, ce nombre peut être petit. En revanche, si l'objectif est de trouver un modèle approprié ou semblable, l'on peut chercher parmi des milliers voire des millions de descripteurs de modèles 3D existants. La Figure 3 illustre en substance un schéma fonctionnel d'un système logiciel lequel peut effectuer les étapes illustrées aux Figures 1 et 2.

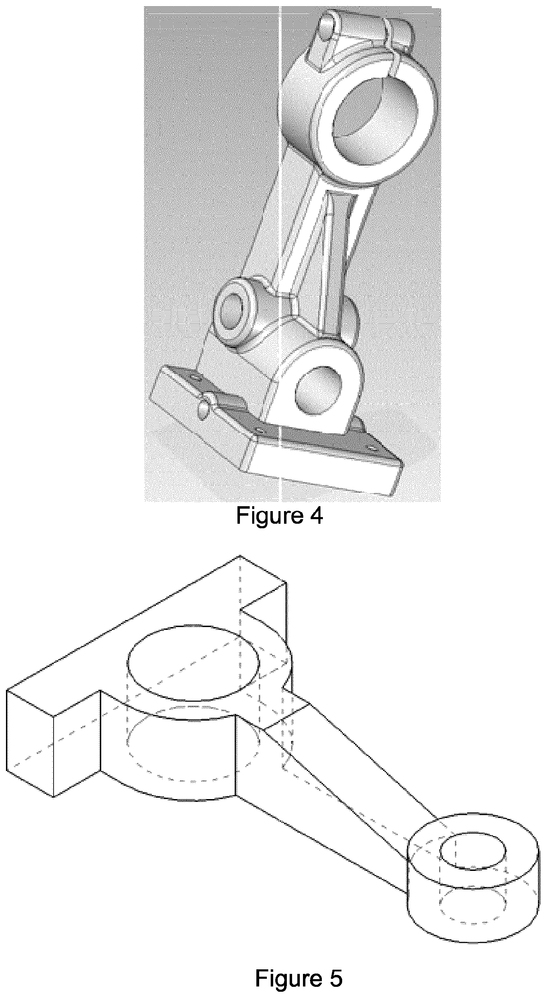

La Figure 4 illustre un exemple d'un modèle 3D d'une pièce. Pour simplifier la description des réalisations suivantes, la Figure 5 montre une version simplifiée du modèle 3D de la Figure 4, et cette version simplifiée sera utilisée dans la description qui suit. La pièce illustrée contient deux ouvertures circulaires de dimension différente dans ses parties supérieure et inférieure et une partie médiane laquelle relie les portions supérieure et inférieure, la partie inférieure susmentionnée étant en forme de base plane.

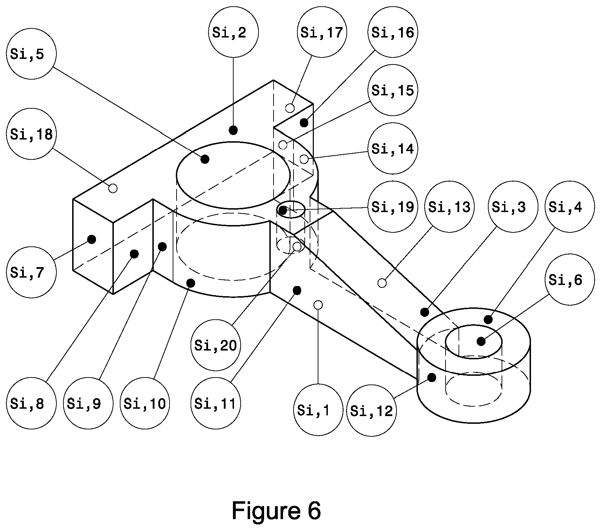

Dans la figure 6, les diverses faces sont marquées de Si,1 à Si,20. L'étiquetage est tout à fait arbitraire, et peut différer d'un modèle 3D à l'autre. Ainsi l'étiquetage *Sm,f* d'une face identifie la face f du modèle 3D m. Le descripteur dans cette réalisation pourrait consister en une liste de caractéristiques, telles le type du modèle 3D (*Type*), les paramètres lesquels dépendent du type (*TypePar*), le volume, dans le cas d'un corps solide, ou l'aire, dans le cas d'une face (*Int(N)*)*,* l'aire pour un corps solide ou le périmètre pour une face (*Int(N-1)*)*,* le centre de gravité (*Gx,y,z*)*,* les moments d'inertie (*M1,2,3*)*,* les axes d'inertie (*Ai x,y,z avec i=1,2,3*) et les dimensions de la boite englobante (*Bx,y,z*) pour chacun des corps solides composant le modèle 3D et pour le modèle 3D complet, ainsi que pour chacune des faces.

La représentation par les frontières ne respecte pas la propriété d'unicité, c'est-à-dire que plus d'une représentation par les frontières peuvent exister pour un modèle 3D donné. Or cette propriété d'unicité est essentielle à la comparaison des modèles 3D. Il est possible par exemple en utilisant des systèmes de modélisation différents (disons deux systèmes de CAO) que le découpage en faces de la frontière d'un modèle 3D ne soit pas toujours unique. Pour remédier à cette situation nous utilisons des faces "Strictement continues G2". Ainsi, des faces peuvent être regroupées pour n'en former qu'une seule si la dérivée seconde géométrique, habituellement notée G2, est continue tout le long d'une arête commune à deux faces. De même, une face dont la surface sous-jacente ne serait pas continue G2 serait scindée en morceaux de sorte que la surface sous-jacente de chaque face soit continue G2. En procédant de cette manière, la propriété d'unicité est rétablie au niveau des faces de la représentation par les frontières.

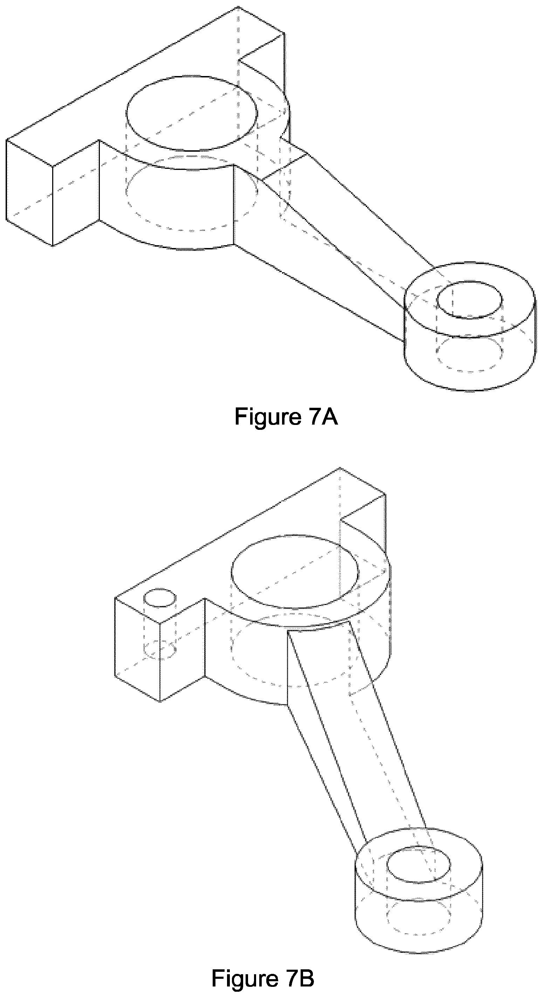

Le tableau 1 donne les valeurs des caractéristiques pour le modèle 3D de la figure 7a. Le lien entre l'identifiant d'un modèle 3D dans le descripteur (colonne *Mod3D*) et le modèle 3D lui-même est réalisé par une table de correspondance par exemple.

La figure 7.b présente un autre exemple de modèles 3D. Le tableau 2 donne les valeurs des caractéristiques de ses descripteurs.

Dans la Figure 1, l'étape de génération des descripteurs est S100. Tous les modèles 3D sont soumis à cette étape, laquelle peut néanmoins être effectuée à des moments différents. Des descripteurs convenables peuvent être stockés avec les données de modèles 3D ou séparément.

À la figure 3, des modèles 3D sont stockés dans un magasin de données S30. Il peut s'agir d'un seul magasin de données ou encore d'un stockage distribué de modèles 3D. Un générateur de descripteurs S32 lit les modèles 3D du magasin de données S30 et sauvegarde les descripteurs dans un deuxième magasin de données S34. Ledit magasin de données S34 peut être intégré au magasin de données S30, ou localisé séparément, même à distance.

Le système peut inclure un système de gestion de modèles 3D S40 lequel contrôle quels modèles 3D seront comparés. Un sélecteur ou générateur de modèle 3D de référence S42 permet à un opérateur de sélectionner ou de créer un modèle 3D de référence. Le descripteur du modèle 3D de référence peut être généré à l'aide du générateur de descripteurs S32 et introduit au moteur de recherche ou de comparaison S50. Le moteur S50 récupère les descripteurs du magasin de données S34.

Le système de la Figure 3 peut résider sur un poste de travail indépendant ou être distribué parmi différents ordinateurs et/ou serveurs afin de faciliter le traitement, le stockage et la gestion des données.

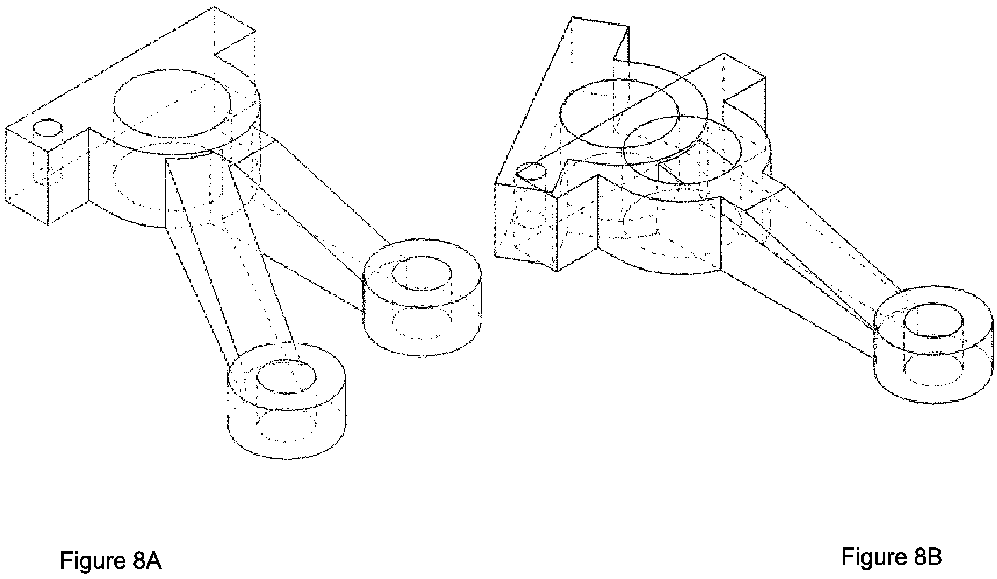

La figure 8A montre le modèle 3D de la Figure 5 sur lequel est superposé un second modèle 3D, soit celui de la figure 7B. Ce dernier présente des différences par rapport au modèle 3D de référence de la figure 7A, à savoir la partie médiane est plus longue (l'entre-axe est passé de 120mm à 150mm, et la partie médiane se connecte à la partie inférieure à un angle différent de 30 degrés. Le modèle 3D de la figure 7A est le modèle 3D de référence sélectionné à l'étape S102 de la figure 1, et le modèle 3D de la figure 7B est celui auquel la référence est comparée pour expliquer la méthode. On comprend que cette comparaison est réalisée pour chaque modèle 3D disponible.

La figure 8B présente les deux modèles 3D dans une position relative différente. Les systèmes décrits dans l'art antérieur n'utilisent qu'une unique position relative pour comparer des modèles 3D entre eux. Cette position est alors déterminée soit, automatiquement à partir des repères propres à chaque modèle 3D, soit par un "best-fit" des deux modèles 3D, soit par un opérateur. L'approche adoptée dans les réalisations suivantes détermine à partir des caractéristiques de face des descripteurs toutes les positions relatives qui permettent de mettre en concordance des caractéristiques de formes (des sous-parties des modèles 3D initiaux) issues des modèles 3D comparés.

Bien qu'une comparaison au niveau des corps solides entre deux modèles 3D puisse produire des résultats utiles à des fins de recherche, elle ne constitue pas un moyen utile pour repérer un modèle 3D à l'intérieur d'un autre modèle 3D (plus complexe), lequel renfermerait une ou des parties du modèle 3D recherché. Une comparaison des faces permet une mise en concordance de celles-ci afin d'identifier les modèles 3D pouvant renfermer potentiellement le modèle 3D recherché. Cette concordance des faces est obtenue par un processus itératif de comparaison des descripteurs en deux étapes, soit une étape d'appariement basée sur les caractéristiques intrinsèques du modèle 3D, par exemple son aire ou ses moments d'inertie, suivie d'une étape de réconciliation basée sur les caractéristiques extrinsèques du modèle 3D, par exemple son centre de gravité ou ses axes d'inertie, ces caractéristiques dépendant du modèle 3D mais aussi du repère dans lequel il est décrit et de manière plus générale de son contexte.

L'identification (au sens étiquetage) des faces sera typiquement différente parmi des modèles 3D comparés; toutefois, dans le cadre de notre exemple simplifié, la numérotation est identique uniquement dans le but de faciliter la compréhension du processus. À l'aide de caractéristiques intrinsèques de faces du descripteur, des faces parmi les modèles 3D sont appariées. Par exemple, les valeurs des caractéristiques aire *Int(N),* périmètre *Int(N-1),* et des trois moments d'inertie *M1,2,3* des faces Si,5; Si,18; Si,6 et Si,4 sont uniques et identiques et donc ces faces sont appariés entre les deux modèles 3D considérés avec un indice de confiance maximale de 1. En revanche, les valeurs intrinsèques pour les faces Si,7; Si,8; Si,16 et Si,17 ne sont pas uniques et entrainent de multiple appariements potentiels de faces, par exemple S1,7 avec {S2,7; 52,8; S2,16; S2;17} ou encore S1,9 avec {S2,9; S2,25}. L'indétermination sera levée lors de l'étape de réconciliation. Pour les faces S1,1; S1,2 et S1,3 avec 52,1; S2,2 et S2,3 respectivement, les valeurs des caractéristiques intrinsèques sont uniques mais certaines valeurs diffèrent entre les faces des deux modèles 3D comparés. Ces faces sont appariées mais l'indice de confiance est inférieur à 1. La manière de calculer cet indice peut varier, nous proposons ici une méthode simple pour alléger la compréhension, soit la sommation de l'indice accordé à chaque caractéristique considérée divisée par le nombre de caractéristiques considérées. Pour un paramètre quantitatif par exemple, l'indice vaut un moins la valeur absolue du rapport entre la différence des valeurs pour cette caractéristique et leur moyenne soit |(Vref-Vcomp/((Vref+Vcomp)/2)|, et pour un paramètre qualitatif, une table de valeurs correspondant aux cas de différence. La méthode est donnée à titre d'exemple et est définie autrement dans d'autres réalisations du processus. Cet indice participe à la détermination de l'indice de ressemblance entre les modèles 3D dans notre réalisation. Dans le cas général, le nombre de faces des deux modèles 3D comparés est différent et à la fin de cette étape certaines faces peuvent ne pas être appariées.

Le résultat de la comparaison des descripteurs pour notre exemple simplifié suivant la réalisation décrite après l'étape d'appariement est donnée dans le tableau 3.

Ce tableau montre une comparaison entre caractéristiques intrinsèques de corps solides qui montre un appariement imparfait (modèles 3D semblables mais non identiques) suivie d'une comparaison entre caractéristiques intrinsèques de faces. Plusieurs cas sont illustrés, soit des appariements uniques parfaits, des appariements multiples avec des valeurs de caractéristiques identiques, des appariements basés sur des valeurs de caractéristiques seulement partiellement identiques et donc avec un indice de confiance inférieur à 1. Les ambigüités sont levées dans une phase subséquente soit la réconciliation.

Le processus d'appariement a été décrit au niveau des faces d'un modèles 3D. On comprend qu'un processus similaire est applicable au niveau d'une pluralité de corps solides, s'ils existent dans les modèles 3D. L'appariement est réalisé en utilisant leurs caractéristiques intrinsèques, comme le volume (*Int(N)*), l'aire (*Int(N-1)*), les trois Moments d'inertie (*M1,2,3*) avec notre exemple de descripteur suivant le même principe. Le processus sert donc aussi à comparer des assemblages de modèles 3D par exemple, ou encore à trouver des sous-systèmes dans des systèmes plus complexes. Dès cette étape (étape S120 de la figure 1), l'indice de confiance correspond à un indice de ressemblance temporaire qui est utilisé pour augmenter l'efficacité de calcul dans le processus. Lorsqu'un modèle 3D possède un indice par rapport au modèle 3D de référence, qui tombe sous un seuil déterminé par l'opérateur, il n'est pas nécessaire d'approfondir plus la comparaison entre les descripteurs et l'indice de similarité (de ressemblance) temporaire (étape S122 dans la Figure 1) fournit une indication rapide sur les modèles 3D potentiellement similaires et permet ainsi de traiter des modèles 3D en grand nombre en ne procédant pas au raffinement de la comparaison lorsque cela n'est pas requis.

L'appariement compare des modèles 3D ou des parties de celui-ci, lesquelles dans notre définition sont également des modèles 3D, que ce soit une face, un ensemble de faces (caractéristiques de formes), un ou plusieurs corps solides, en analysant des paramètres intrinsèques du descripteur. À ce stade chaque modèle 3D est considéré de manière isolée sans tenir compte notamment de sa position relative par rapport aux autres modèles 3D.

Bien que l'échelle d'un modèle 3D puisse généralement être considérée comme étant bien définie, et ainsi qu'un indice de confiance faible sur des caractéristiques dimensionnelles peut constituer un motif pour rejeter un appariement, on comprend que dans certains cas, un facteur d'échelle peut être déterminé lors du processus d'appariement des faces, et que l'appariement puisse ainsi être réalisé, pour un facteur d'échelle donné.

L'ajout des données dans les lignes du tableau pour chaque modèle 3D qui est comparé au modèle 3D de référence constitue l'étape S124 de la figure 1. Lorsqu'un nombre suffisant de modèles 3D similaires est atteint ou lorsque tous les descripteurs disponibles ont été comparés, à l'étape S126 le processus de raffinement de la comparaison se poursuit. Dès lors, on peut identifier les modèles 3D les plus semblables en fonction par exemple du nombre de faces appariées ou du rapport du total des aires des faces appariées sur la somme des aires de toutes les faces ou toute autre fonction qui déterminerait un indice de ressemblance temporaire. Dans la figure 1, le processus continue avec l'étape de la réconciliation des modèles 3D, lesquels sont selon notre définition une ou des faces ou un ou des corps solides. Il pourrait alors se concentrer sur les modèles 3D les plus prometteurs.

Relativement à la Figure 3, le moteur de comparaison S52 effectue la comparaison des descripteurs et le stockage des données de comparaison présentées dans les tableaux est réalisé dans le magasin de données S54. Le moteur S50 contrôle le processus et effectue le calcul de l'indice de similarité.

L'étape de réconciliation S140 de la figure 1 consiste à prendre en compte les caractéristiques extrinsèques des descripteurs et notamment les positions relatives des modèles 3D entre eux. À partir des appariements certains (indice de confiance = 1), des matrices de changement de repère sont déterminées lesquelles repositionnent les modèles 3D comparés dans un repère commun, par exemple, le repère du modèle 3D de référence. La détermination de ces matrices est une opération assez routinière et connue dans l'état de la technique. A ce stade, plusieurs matrices de changement de repère sont créées. En les appliquant aux modèles 3D, on constate que certaines d'entre elles ne réconcilient que les modèles 3D qui ont servis à les déterminer. Leur pertinence est faible et elles sont discriminées à l'étape S142.

On comprend que l'on peut calculer les transformations ou les matrices de changement de repère entre toutes les caractéristiques géométriques des descripteurs (parties des modèles 3D, comme par exemples des faces) et ensuite retrouver au moins un groupe de transformations identiques (tenant compte des tolérances de calcul), comme on peut calculer une transformation pour une première caractéristique (ex. une première face) et ensuite tenter d'appliquer cette transformation à d'autres caractéristiques. De cette manière, on peut développer un groupe de caractéristiques ayant une transformation commune.

Pour chaque repositionnement obtenu en appliquant les matrices de changement de repère retenues, la comparaison des caractéristiques extrinsèques est effectuée (étape 144). Dans notre exemple, deux matrices sont ainsi retenues. Une première matrice M1 positionne les modèles 3D tel qu'illustré par la figure 8A. Les faces Si,5 Si,6 et Si,18 qui étaient déjà appariées avec certitude sont réconciliées et concordent, elles sont déclarées identiques pour cette mise en position particulière. En appliquant cette matrice, les ambiguïtés d'appariement des faces Si,7; Si,8; Si,9; Si,15; Si,16 et Si,17 sont levées. Ces faces sont réconciliées et sont aussi déclarées identiques pour cette mise en position. Enfin en comparant les caractéristiques extrinsèques des descripteurs des faces S1,2 et S1,10 avec S2,10 et 52,14 on constate que plusieurs valeurs sont identiques et d'autres sont différentes. Ces faces sont réconciliées avec un indice de confiance inférieure à 1. Elles sont différentes et ces différences sont qualifiables à partir de la comparaison des descripteurs comme nous le montrerons à l'étape du marquage. L'application de la deuxième matrice M2 positionne les modèles 3D tels que représentés par la figure 8B. Les faces Si,4 et Si,6 appariées avec certitude, sont réconciliées, concordent et donc sont déclarées identiques pour cette seconde mise en position. Enfin les faces Si,11; Si,12 et Si,13 sont réconciliées avec un indice inférieure à 1 et donc avec des différences pour cette mise en position particulière. Dépendant du seuil fixé sur l'indice de confiance, une face telle que Si,3 est aussi réconciliée. Il est aussi possible que plusieurs matrices de changement de repère conduisent à réconcilier des faces plusieurs fois. Dans ce cas, la réconciliation donnant le meilleur indice de confiance est conservée. Ces matrices ne contribuent pas à résoudre toutes les ambiguïtés dans tous les cas et certaines faces restent orphelines. Il s'agit de nouvelles faces ou de faces fortement modifiées.

Le tableau 4 complété par les données ajoutées par l'étape de réconciliation est présenté pour notre exemple. Ce tableau peut être stocké en conservant toutes les données ou uniquement celles d'intérêt pour la suite du processus et les besoins de l'opérateur.

L'on s'aperçoit que le principe du multi positionnement introduit dans cette invention redéfinit complètement la notion de comparaison et de différence entre modèles 3D et autorise la comparaison de parties de modèles 3D (form features). Ainsi la comparaison peut être effectuée, en utilisant toutes les matrices de mise en positon, en privilégiant une ou plusieurs matrices particulières, voire même en contraignant la détermination d'une matrice basée sur certaines caractéristiques des descripteurs sélectionnées par l'opérateur. On comprend qu'à l'étape S146, il est possible de calculer des indices de ressemblances qui dépendent de ces choix.

On peut maintenant tronquer le tableau des données de comparaison afin d'y enlever les appariements multiples et ambigües de faces issus de l'étape d'appariement en raison des valeurs de leurs caractéristiques intrinsèques, et dont la non pertinence est montrée lors de la réconciliation (étape S148). Le tableau 5 illustre les données de comparaison après le nettoyage pour notre exemple.

Le processus de raffinement de la comparaison se poursuit jusqu'à ce qu'un nombre suffisant de modèles 3D similaires soit atteint ou que tous les descripteurs disponibles aient été comparés, à l'étape S150.

On comprend qu'un tel processus de comparaison entre des modèles 3D, est utile pour de nombreuses applications comme retrouver des modèles 3D similaires, les classer en fonction d'un indice de ressemblance, faire une classification (clustering) de ces modèles 3D, mettre en évidence les caractéristiques identiques ou différentes ou encore permettre une identification et une réconciliation des références lorsqu'un modèle 3D est substitué à un modèle 3D de référence.

Le moteur de réconciliation S56 (voir Figure 3) effectue les opérations susmentionnées et met à jour les données dans le magasin de données S54.

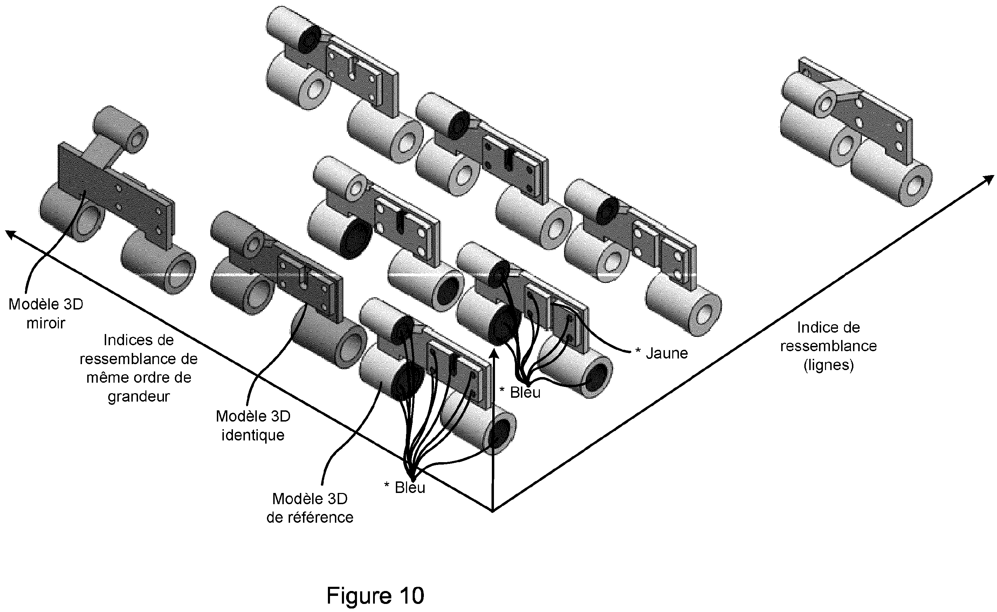

En référence à la Figure 3, les modèles 3D possédant la plus grande ressemblance par rapport au modèle 3D de référence, identifiés comme tels par le moteur S50 lequel s'appuie sur les données du tableau dans le magasin de données S54 alimenté par les moteurs S52 et S56, sont désormais prêts à être présentés à l'opérateur grâce au système d'affichage S46. Le système S46 génère la vue désirée des modèles 3D. Pour ce faire, il accède aux modèles 3D stockés dans le magasin de données S30 et le moteur de marquage S45 utilise des données de comparaison du magasin de données S54 afin de marquer les faces identiques ou différentes, ou encore d'autres caractéristiques des modèles 3D. L'opérateur sélectionne les paramètres ou critères de marquage désirés grâce à l'interface S44, laquelle permet également de sélectionner les propriétés et fonctions qui déterminent la disposition des modèles 3D dans l'espace de dimension 3 générée par le système S46. Dans certaines réalisations S46 utilise un système de CAO ou encore un navigateur internet (web browser) pour l'affichage des résultats en 3D. La disposition et le marquage des modèles 3D affichés varient selon les besoins de l'opérateur. Par exemple dans certains cas, l'opérateur veut mettre en évidence les parties identiques des modèles 3D pour une mise en position particulière, pour de multiples mises en position ou encore mettre en évidence des différences d'une ou plusieurs caractéristiques. Cette manière de communiquer la comparaison simultanément de plusieurs modèles 3D basée sur le marquage et la position des modèles 3D dans une scène en 3D, telle qu'illustrée à la Figure 10 est totalement inédite.

On comprend que lorsque des modèles 3D sont comparés dans le processus proposé, plusieurs types de différences entre face, ensembles de faces (form features) et corps solides sont déterminés. Le marquage les distingue suivant les requêtes formulées par l'opérateur. Voici quelques exemples illustrant des types de différences en fonction des besoins de l'opérateur. Dans le premier exemple, l'opérateur cherche dans un ensemble de modèles 3D, des caractéristiques de formes identiques à celles présentent dans le modèle 3D de référence sans les préciser. Dans ce cas, le processus met en œuvre l'appairage, la réconciliation, le multi repositionnement et marque les faces en conséquence. Les faces Si,4; Si,5; Si,6; Si,7; Si,8; Si,9; Si,15; Si,16; Si,17; Si,18 respectivement sur les modèles 3D de référence (i=1) et comparé (i=2), concordent totalement pour l'une des mises en position données et sont donc qualifiées d'identiques et marquées en conséquence (comme par exemple par une couleur, soit bleu). Les faces Si,1; Si,2; Si,11; Si,13 et la face S1,10; S1,14 avec la face S2,10 des modèles 3D sont d'abord appariées avec un indice de confiance faible lequel est revu à la hausse lors de la réconciliation. Ces faces sont finalement marquées comme géométriquement identiques avec des topologies différentes (utilisation par exemple de la couleur verte) car elles partagent les mêmes caractéristiques géométriques (axe et rayon pour les faces cylindriques S1,10; S1,14 et 52,10 et normal et position pour les faces planes Si,1; Si,2; Si,11; Si,13) mais diffèrent sur d'autres valeurs des descripteurs qui caractérisent leur topologie (périmètre par exemple dans nos descripteurs). L'appariement et la réconciliation des descripteurs de la face Si,13 des modèles 3D comparés ne permettent pas de conclure avec une grande confiance qu'il s'agit de la même face modifiée. Rendu à ce stade il reste peu de faces non réconciliées et il s'agit du meilleur choix restant. Dans ce cas, la caractéristique Type est identique et dépendant du seuil sur l'indice de confiance, elle sera déclarée "réconciliée et différente" (par exemple couleur mauve) ou tout simplement "non réconciliée et nouvelle" (par exemple couleur rouge). Les faces sont différentes tant du point de vue de leur géométrie que de leur topologie pour toutes les remises en position retenues. Les faces S2,19 et S2,20 quant à elles sont déclarées "non-réconciliées", donc nouvelles (couleur rouge).

Dans un autre exemple, l'opérateur sélectionne, par l'intermédiaire de l'interface 44 (figure 3), une partie du modèle 3D (qui devient de facto le modèle 3D de référence), qui représente les faces fonctionnelles ou les faces en contact avec d'autres composants (interfaces), soit pour illustrer, les faces S1,5; S1,1; S1,18 qui servent également à définir une mise en position pour l'étape de la réconciliation, ainsi que les faces S1,6; S1,4. Pour faciliter l'interprétation des résultats, il demande que les faces identiques sur les modèles 3D trouvés soit marquées en bleu, que les faces réconciliées et géométriquement identiques mais dont la topologie est différente soient marquées en cyan et finalement que les autres faces (non prise en compte, non réconciliée, nouvelles) soient grisées et transparentes. Avec les modèles 3D de la figure 7A et 7B, on obtient 52,5; S2,18 identiques (donc en bleu), S2,1; 52,4; S2,6 géométriquement identiques (donc en cyan) et toutes les autres faces ne sont pas considérées (donc gris, transparent).

On comprend que l'opérateur, par l'intermédiaire d'une interface 44 appropriée peut définir des contraintes extrêmement précises comme par exemple imposée l'entre-axe et les diamètres des faces Si,5 et Si,6 ou encore le parallélisme et la distance entre Si,11 et Si13. Toutes ces contraintes sont calculables à partir des caractéristiques des descripteurs présentés dans cette réalisation.

Le fait d'afficher un modèle 3D avec un étiquetage ou encore avec des textures ou des couleurs différentes pour des faces particulières est connu dans l'état de la technique.

Les différences sont représentées par des couleurs, des transparences, des textures, des hachures, des annotations ou tout autre effet graphique que nous regroupons sous le terme de marquage. La ressemblance, c'est à dire moins de différences suivant les critères de l'opérateur, entre les modèles 3D est représentée par leur position dans l'espace 3D.

On comprend qu'une vaste gamme de marquage peut être utilisée. Ainsi, la similarité est exprimée par les positions respectives dans l'espace 3D des modèles 3D obtenues par la fonction qui calcule l'indice de ressemblance, mais elle peut également être appréciée à partir du marquage des différences des modèles 3D. Par exemple, si un perçage comparé à un perçage du modèle 3D de référence est plus petit en diamètre mais que son axe est le même, il sera marqué d'une certaine façon; par contre, si son diamètre et son axe sont différents, ce perçage est marqué d'une autre façon pour différencier les deux types de différences.

Dans certaines réalisations, le processus de comparaison des descripteurs est influencé par la définition de caractéristiques d'intérêt ou encore par celles au contraire qui ne présentent pas d'intérêt. Cette définition peut être précisée par l'opérateur de façon explicite ou implicite. À l'étape S152 de la figure 1, les modèles 3D sont sélectionnés selon les indices de ressemblance et les critères exprimés par l'opérateur. Les résultats sont mis en forme et affichés à l'étape S160. Parmi d'autres formes possibles, l'affichage des modèles 3D dans un espace 3D comme l'illustre la figure 10, avec la mise en évidence par un marquage, tel que décrit plus haut, des similarités et des différences et l'utilisation du positionnement dans l'espace des modèles 3D est une nouveauté et représente la manière privilégiée de communiquer les résultats. On comprend que ces résultats peuvent également être transmis sous une forme textuelle (tableau, liste ou autre forme).

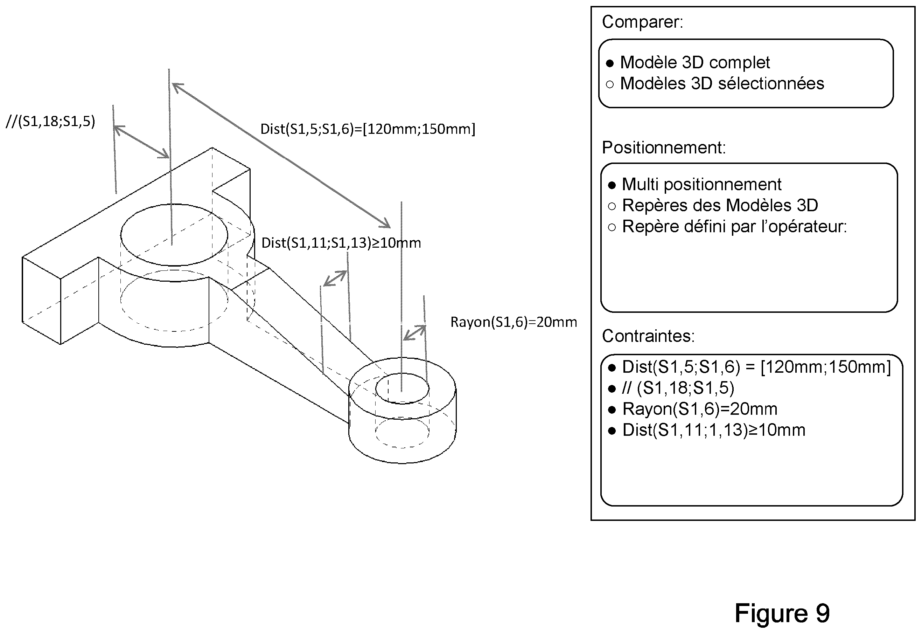

La Figure 9A montre le modèle 3D simplifié de la figure 5 et un exemple d'interface pour la définition des contraintes de comparaison. Dans le cas présenté, le modèle 3D complet est pris en compte pour faire la comparaison en autorisant le multi repositionnement pour déterminer la ressemblance, et des contraintes ont été imposées comme la distance entre les axes des cylindres Si,5 et Si,6 doit être comprise entre 120 et 150mm les faces Si,18 et tSi,5 doivent être parallèles, Si,6 doit avoir un rayon de 20mm et finalement la distance entre les faces Si,11 et Si,13 doit être supérieure à 10mm. La détermination de ces contraintes peut se faire notamment à l'aide de l'interface de détermination de contraintes S48 tel que montré à la figure 3. L'opérateur a la possibilité de définir si tout le modèle 3D est pris en considération dans le processus ou si seulement une sous-partie de celui-ci est à considérer. La figure 2 donne un exemple des étapes impliquées dans une comparaison à partir de l'indication d'importance d'attributs, tels des faces des modèles. Dans ce cas, Il sélectionne les sous-ensembles du modèle 3D à retenir (qui sont aussi des modèles 3D) et pour chaque sous-ensemble il indique s'il doit être identique ou seulement similaire dans les modèles 3D comparés. L'opérateur choisit également s'il autorise le multi repositionnement ou impose un repère de comparaison soit celui des modèles 3D ou un repère construit à partir de contraintes qu'il impose. Enfin, l'opérateur peut définir des contraintes auxquelles il apporte une plus grande importance, comme un entre-axe compris entre 120 et 150mm pour les deux cylindres Si,5 et Si,6, un rayon de 20mm pour le cylindre Si,6 et une distance supérieure ou égale à 10mm pour les faces Si,11 et Si,13. L'opérateur construit donc les contraintes directement sur les caractéristiques explicites des descripteurs (Rayon de Si,6 = 20mm) mais également implicites (Distances entre axes Si,5 et Si,6 ou parallélisme entre Si,18 et Si,5). De telles caractéristiques implicites sont ajoutées dans les tableaux contenant les résultats de comparaison (colonnes supplémentaires) pour participer au calcul de l'indice de ressemble.

Cette manière de définir des contraintes ressemble à celles que proposent les systèmes de CAO pour contraindre des esquisses ou des assemblages et est connue dans l'état de la technique.

On comprend que l'inventaire des propriétés ou contraintes disponibles, leur mode de sélection, leur disposition et ordonnancement, ainsi que la manière dont elles sont pondérées peuvent faire l'objet d'une multitude de variations sans pour autant modifier la fonctionnalité sous-jacente. Plutôt que d'offrir une simple sélection binaire (distinguant une sélection « retenue/importante » d'une autre « non-retenue/non-importante »), l'interface pourrait, par exemple, accepter une valeur de pondération exprimée en pourcentage d'importance ou une autre valeur calibrée. De même, l'opérateur peut éliminer des parties de modèles 3D qu'il estime insignifiant pour sa requête, comme les corps solides inférieures à une certaine dimension (taille de la boite englobante) ou volume, ou encore des faces dont l'aire serait inférieure à un certain pourcentage de l'aire totale du modèle 3D (simplification du modèle 3D). Il est tout aussi possible de contraindre la comparaison par un volume d'occupation maximale (réservation d'espace dans un assemblage).

Durant le processus de comparaison, des contraintes comme par exemple, celle exprimant la distance entre les deux cylindres peuvent servir de filtre (Go/No Go) ou intervenir seulement au marquage en montrant que la contrainte est satisfaite ou au contraire non satisfaite. Ces contraintes interviennent éventuellement aussi au niveau du calcul de l'indice de ressemblance qui peut alors être vu comme un indice de conformité aux contraintes.

On comprend que lorsque les contraintes sont modifiées, tout le processus peut être recommencé ou simplement le calcul de l'indice de ressemblance et le marquage des modèles 3D déjà sélectionnés.

Dans certaines réalisations, des modèles 3D sont ordonnés suite au processus de comparaison basé sur l'appariement et la réconciliation des descripteurs en fonction de l'indice de ressemblance calculé. La figure 10 illustre un exemple de huit modèles 3D d'une pièce de charnière qui ressemblent au modèle 3D de référence (c'est-à-dire au modèle 3D ayant servi à la comparaison aux fins de la recherche présentée) positionnés dans une scène 3D (par exemple un assemblage dans les systèmes de CAO) suivant une vue isométrique dont l'opérateur peut évidemment modifier le point de vue.

Le modèle 3D ayant servi de référence est positionné à l'origine (soit le coin en bas à droite), les faces en bleu (repérées par une *) sont prises en compte dans le marquage des différences après la comparaison, les faces en gris (faces non repérées) ne seront pas marquées qu'elles soient identiques ou différentes pour faciliter l'interprétation des résultats par exemple. Les modèles 3D semblables sont positionnés dans l'espace 3D est utilisant des critères associés aux trois axes. Le marquage (couleurs, textures, transparences, annotations, etc.) peut représenter d'autres critères ou information. En particulier, dans cette figure, l'un des axes est utilisé pour représenter un indice de ressemblance. Plus un modèle 3D diffère du modèle 3D de référence et plus la distance augmente selon cet axe. Des modèles 3D qui possèdent un indice de ressemblance du même ordre de grandeur sont regroupés selon le second axe. Ainsi dans la première rangée directement à côté du modèle de référence apparaissent deux modèles 3D, l'un identique et l'autre miroir (symétrie plane). Dans la deuxième rangée est positionné le seul modèle 3D trouvé qui est différent mais satisfait à toutes les contraintes (aucune face en jaune, soit aucune face repérée dans la figure jointe). Dans les rangées suivantes, apparaissent des modèles 3D qui ne satisfont pas toutes les contraintes et qui diffèrent de plus en plus du modèle de référence. Le premier modèle 3D de la troisième rangée a une rainure différente et les faces sont marquées en conséquence (en jaune, soit repéré par une * dans cette figure). Le modèle suivant différent au niveau des quatre perçages et de l'alésage (toutes les faces repérées par *).

Le troisième axe qui n'est pas utilisé dans cet exemple peut servir à représenter une autre information comme les versions, la provenance, les états de fabrication ou toute autre classification des modèles 3D qui représente un intérêt pour l'opérateur.

On comprend que le modèle 3D de référence peut être dérivé d'un composant (pièce ou mécanisme) existant numérisé ou encore d'un modèle 3D esquissé plus ou moins grossièrement par l'opérateur à l'écran. Dans ce dernier cas, l'opérateur peut avoir omis certains détails qui apparaissent néanmoins parmi les modèles 3D résultant de la recherche. On comprend qu'une interface autorise l'opérateur à basculer du modèle de référence initial vers l'un des modèles 3D figurant parmi les résultats de la recherche. Lorsque le modèle 3D de référence est substitué, l'opérateur peut facultativement maintenir les contraintes de la comparaison précédente ou en définir de nouvelles.

On comprend que le système de comparaison de modèle 3D décrit ci-dessus peut constituer un outil puissant dans la recherche, l'analyse ou l'organisation des modèles 3D. Dans de nombreux milieux industrielsnotamment, l'utilisation du système ainsi que des méthodes décrites ci-dessus permettent un gain de temps tout au long du cycle de vie des produits, notamment au stade de la conception et de la fabrication des produits.

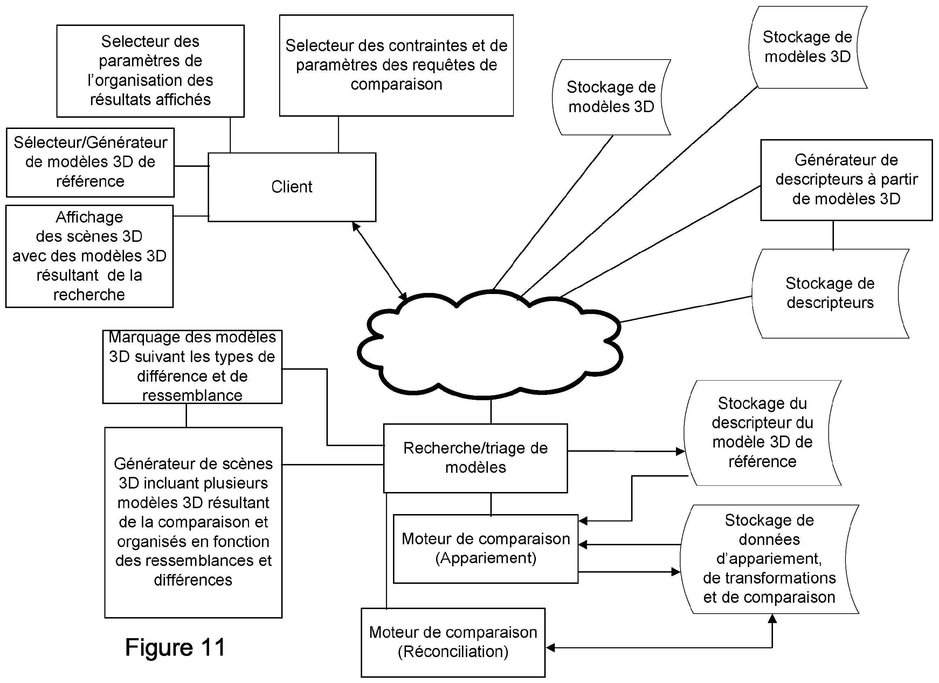

Tel qu'illustré à la figure 11, le système de la figure 3 peut être déployé de façon distribuée sur plusieurs ordinateurs, sur la toile (le web) ou sur un intranet, permettant un accès à distance à un opérateur à des magasins de données de modèles 3D, à des magasins de descripteurs, à des moteurs de recherche et de comparaison, de marquage ou aux autres modules complémentaires. Dans l'exemple de la figure 11, les tâches de recherche et de comparaison sont effectuées par un serveur distant du poste de travail de l'opérateur. Le moteur de marquage et de calcul de la scène 3D associée, accompagnent le serveur de recherche. Dans une autre réalisation, il pourrait aussi être du côté du client. La scène 3D et les modèles 3D sont envoyés à l'opérateur pour une exploitation dans un fureteur internet (web browser) par exemple. De même, le stockage des descripteurs est, d'après l'illustration qui en est faite, hébergé à distance. La génération des descripteurs peut constituer un service séparé pour les magasins de données de modèles 3D. Le système de la figure 11 montre également trois magasins de données à distance distincts de modèles 3D.

L'utilisation d'un tel système permet à un opérateur de fureter, de rechercher, et de comparer des modèles 3D d'une pluralité de sources depuis un seul et même poste de travail client.

L'utilisation d'un tel système permet à un opérateur de téléverser ses modèles 3D existants pour fins de génération de descripteurs en utilisant un service à distance, que ses modèles 3D soient pour recherche et comparaison par lui et lui seul, ou pour une recherche et comparaison faites par d'autres également.

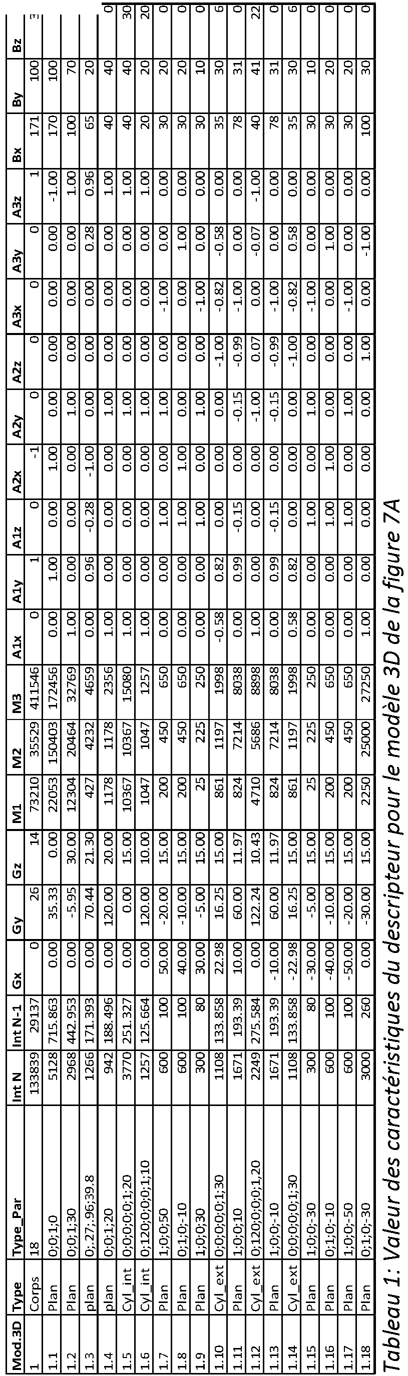

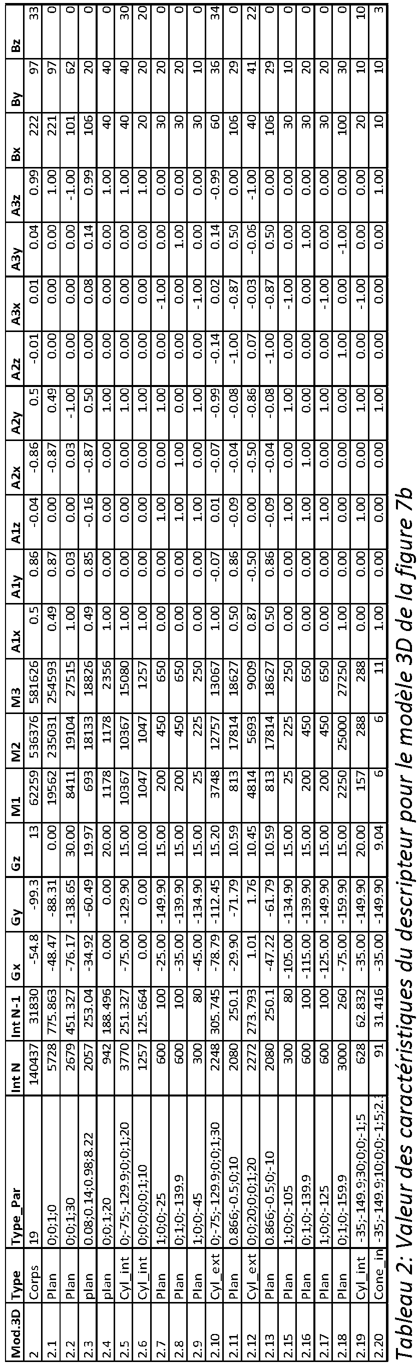

**Tableau 3: Résultat après appariement des modèles 3D**

| **Mod.3D** | **Type** | **Int N** | **Int N-1** | **M1** | **M2** | **M3** | **Bx** | **By** | **Bz** | **Indice App.** |
|---|---|---|---|---|---|---|---|---|---|---|
| 1 | Corps | 133839 | 29137 | 73210 | 35529 | 411546 | 171 | 100 | 33 | |
| 2 | Corps | 140437 | 31830 | 62259 | 536376 | 581626 | 222 | 97 | 33 | |
| Indice | 1.00 | 0.98 | 0.96 | 0.92 | 0.12 | 0.83 | 0.87 | 0.98 | 0.99 | 0.85 |
| 1.1 | Plan | 5128 | 716 | 22053 | 150403 | 172456 | 170 | 100 | 0 | |
| 2.1 | Plan | 5728 | 776 | 19562 | 235031 | 254593 | 221 | 97 | 0 | |
| Indice | 1.00 | 0.94 | 0. 96 | 0.94 | 0.78 | 0.81 | 0.87 | 0.98 | 1.00 | 0.92 |
| 1.2 | Plan | 2968 | 443 | 12304 | 20464 | 32769 | 100 | 70 | 0 | |
| 2.1 | Plan | 5728 | 776 | 19562 | 235031 | 254593 | 221 | 97 | 0 | |
| Indice | 1.00 | 0.68 | 0.73 | 0.77 | 0.16 | 0.23 | 0.62 | 0.84 | 1.00 | 0.67 |
| 1.3 | plan | 1266 | 171 | 427 | 4232 | 4659 | 65 | 20 | 0 | |
| 2.3 | plan | 2057 | 253 | 693 | 18133 | 18826 | 106 | 20 | 0 | |
| Indice | 1.00 | 0.76 | 0.81 | 0.76 | 0.38 | 0.40 | 0.76 | 1.00 | 0.87 | 0.75 |
| 1.4 | plan | 942 | 188 | 1178 | 1178 | 2356 | 40 | 40 | 0 | |
| 24 | plan | 942 | 188 | 1178 | 1178 | 2356 | 40 | 40 | 0 | |
| Indice | 1.00 | 1.00 | 1.00 | 1.00 | 1.00 | 1.00 | 1.00 | 1.00 | 1.00 | 1.00 |
| 1.5 | Cyl_int | 3770 | 251 | 10367 | 10367 | 15080 | 40 | 40 | 30 | |
| 2.5 | Cyl_int | 3770 | 251 | 10367 | 10367 | 15080 | 40 | 40 | 30 | |
| Indice | 1.00 | 1.00 | 1.00 | 1.00 | 1.00 | 1.00 | 1.00 | 1.00 | 1.00 | 1.00 |
| 1.6 | Cyl_int | 1257 | 126 | 1047 | 1047 | 1257 | 20 | 20 | 20 | |
| 2.6 | Cyl_int | 1257 | 126 | 1047 | 1047 | 1257 | 20 | 20 | 20 | |
| Indice | 1.00 | 1.00 | 1.00 | 1.00 | 1.00 | 1.00 | 1.00 | 1.00 | 1.00 | 1.00 |
| 1.7 | Plan | 600 | 1.00 | 200 | 450 | 650 | 30 | 20 | 0 | |
| 2.7 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.8 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.16 | Plan | 600 | 1.00 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.17 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 1.8 | Plan | 600 | 100 | 200 | 450 | 650 | 30 | 20 | 0 | |
| 2.7 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.8 | Plan | 600 | 100 | 200 | 450 | 650 | 30 | 20 | 0 | |
| Indice | 1.00 | 1.00 | 1.00 | 100 | 1.00 | 1.00 | 1.00 | 1.00 | 1.00 | 1.00 |
| 2.16 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.17 | Plan | 600 | 100 | 200 | 450 | 650 | 30 | 20 | 0 | |
| Indice | 1.00 | 1.00 | 1.00 | 1.00 | 1.00 | 1.00 | 1.00 | 100 | 1.00 | 1.00 |
| 1.9 | Plan | 300 | 80 | 25 | 225 | 250 | 30 | 10 | 0 | |
| 2.9 | Plan | 300 | 80 | 25 | 225 | 250 | 30 | 10 | 0 | |
| Indice | 1.00 | 1.00 | 1.00 | 1.00 | 1.00 | 1.00 | 1.00 | 1.00 | 1.00 | 1.00 |
| 2.15 | Plan | 300 | 80 | 25 | 225 | 250 | 30 | 10 | 0 | |
| Indice | 1.00 | 1.00 | 1.00 | 1.00 | 1.00 | 1.00 | 1.00 | 1.00 | 1.00 | 1.00 |
| 1.10 | Cyl_ext | 1108 | 134 | 861 | 1197 | 1998 | 35 | 30 | 6 | |
| 2.10 | Cyl_ext | 2248 | 306 | 3748 | 12757 | 13067 | 60 | 36 | 34 | |
| Indice | 1.00 | 0.66 | 0.61 | 0.37 | 0.17 | 0.27 | 0.73 | 0.91 | 0.28 | 0.56 |
| 1.11 | Plan | 1671 | 193 | 824 | 7214 | 8038 | 78 | 31 | 0 | |
| 2.11 | Plan | 2080 | 250 | 813 | 17814 | 18627 | 106 | 29 | 0 | |
| Indice | 1.00 | 0.89 | 0.87 | 0.99 | 0 58 | 0.60 | 0.85 | 0.95 | 0.00 | 0.75 |
| 2.13 | Plan | 2080 | 250 | 813 | 17814 | 18627 | 106 | 29 | 0 | |
| Indice | 1.00 | 0.89 | 0.87 | 0.99 | 0 58 | 0.60 | 0.85 | 0.95 | 0.00 | 0.75 |
| 1.12 | Cyl_ext | 2249 | 276 | 4710 | 5686 | 8898 | 40 | 41 | 22 | |
| 2.12 | Cyl_ext | 2272 | 274 | 4814 | 5693 | 9009 | 40 | 41 | 22 | |
| Indice | 1.00 | 0.99 | 1.00 | 0.99 | 1.00 | 0.99 | 1.00 | 1.00 | 1.00 | 1.00 |
| 1.13 | Plan | 1671 | 193 | B24 | 7214 | 8038 | 78 | 31 | 0 | |
| 2.11 | Plan | 2080 | 250 | 813 | 17814 | 18627 | 106 | 29 | 0 | |
| Indice | 1.00 | 0.89 | 0.87 | 0.99 | 0 58 | 0.60 | 0.85 | 0.95 | 0.00 | 0.75 |
| 2.13 | Plan | 2080 | 250 | 813 | 17814 | 18627 | 106 | 29 | 0 | |
| Indice | 1.00 | 0.89 | 0.87 | 0.99 | 0 58 | 0.60 | 0.85 | 0.95 | 0.00 | 0.75 |
| 1.14 | Cyl_ext | 1108 | 134 | 861 | 1197 | 1998 | 35 | 30 | 6 | |
| 2.10 | Cyl_ext | 2248 | 306 | 3748 | 12757 | 13067 | 60 | 36 | 34 | |
| Indice | 1.00 | 0.66 | 0.61 | 0.37 | 0.17 | 0.27 | 0.73 | 0.91 | 0.28 | 0.56 |
| 1.15 | Plan | 300 | 80 | 25 | 225 | 250 | 30 | 10 | 0 | |
| 2.9 | Plan | 300 | 80 | 25 | 225 | 250 | 30 | 10 | 0 | |
| Indice | 1.00 | 1.00 | 1.00 | 1.00 | 1.00 | 1.00 | 1.00 | 1.00 | 1.00 | 1.00 |
| 2.15 | Plan | 300 | 80 | 25 | 225 | 250 | 30 | 10 | 0 | |
| Indice | 1.00 | 1.00 | 1.00 | 1.00 | 1.00 | 1.00 | 1.00 | 1.00 | 1.00 | 1.00 |
| 1.16 | Plan | 600 | 100 | 200 | 450 | 650 | 30 | 20 | 0 | |
| 27 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.8 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.16 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.17 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 1.17 | Plan | 600 | 100 | 200 | 450 | 650 | 30 | 20 | 0 | |
| 27 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.8 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.16 | Plan | 600 | 1.00 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 2.17 | Plan | 600 | 100 | 200 | 450 | 650 | 30 | 20 | 0 | |
| Indice | 1.00 | 1.00 | 1.00 | 1.00 | 1.00 | 1.00 | 1.00 | 1.00 | 1.00 | 1.00 |
| 1.18 | Plan | 3000 | 260 | 2250 | 25000 | 27250 | 1.00 | 20 | 0 | |
| 2.18 | Plan | 3000 | 260 | 2250 | 25000 | 27250 | 100 | 30 | 0 | |
| Indice | 1.00 | 1.00 | 1.00 | 1.00 | 1.00 | 1.00 | 1.00 | 1.00 | 1.00 | 1.00 |
| 1.-- | - | - | - | - | - | - | - | - | - | |
| 2.19 | Cyl_int | 628 | 63 | 157 | 288 | 288 | 20 | 10 | 10 | |
| Indice | 0.00 | 0.00 | 0.00 | 0.00 | 0.00 | 0.00 | 0.00 | 0.00 | 0.00 | 0.00 |
| 1.-- | - | - | - | - | - | - | - | - | - | |
| 2.20 | Cone_int | 91 | 31 | 6 | 6 | 11 | 10 | 10 | 3 | |
| Indice | 0.00 | 0.00 | 0.00 | 0.00 | 0.00 | 0.00 | 0.00 | 0.00 | 0.00 | 0.00 |

**Tableau 4: Résultat après appariement et réconciliation des modèles 3D**

| **Mod.3D** | **Type** | **Type_Par** | **Gx** | **Gy** | **Gz** | **A1x** | **A1v** | **A1z** | **A2x** | **A2y** | **A2z** | **A3x** | **A3y** | **A3z** | **Matrice** | **Indice** |
|---|---|---|---|---|---|---|---|---|---|---|---|---|---|---|---|---|
| 1 | Corps | 18 | 0.00 | 25.80 | 13.60 | 0.00 | 1.00 | 0.04 | -1.00 | 0.00 | 0.00 | 0.00 | 0.04 | 1.00 | | |
| 2 | Corps | 19 | 2.147 | 6.539 | 13. 002 | 0.00 | 1.00 | -0.04 | -1.00 | 0.00 | -0.01 | -0.01 | 0.04 | 0.99 | 2 | |
| Indice | 1 | 0.97 | 0.98 | 0.91 | 0.98 | 1.00 | 1.00 | 0.94 | 1.00 | 1.00 | 1.00 | 1.00 | 1.00 | 1.00 | | 0.98 |
| 1.1 | Plan | 0,0;1;0 | 0.00 | 35.33 | 0.00 | 0.00 | 1.00 | 0.00 | 1.00 | 0.00 | 0.00 | 0.00 | 0.00 | -1.00 | | |
| 2.1 | Plan | 0,0;1;0 | 2.18 | 19.29 | 0.00 | -0.01 | 1.00 | 0.00 | -1.00 | -0.01 | 0.00 | 0.00 | 0.00 | 1.00 | 2 | |
| Indice | 1 | 1.00 | 0.98 | 0.92 | 1.00 | 0.99 | 1.00 | 1.00 | 0.00 | 1. 00 | 1.00 | 1.00 | 1.00 | 0.00 | | 0.85 |
| 1.2 | Plan | 0,0;1;30 | 0.00 | -5.95 | 30.00 | 1.00 | 0.00 | 0.00 | 0.00 | 1.00 | 0.00 | 0.00 | 0.00 | 1.00 | | |
| 2.2 | Plan | 0,0;1;30 | -1.17 | -8.75 | 30.00 | 1.00 | 0.03 | 0.00 | 0.03 | -1 00 | 0.00 | 0.00 | 0.00 | -1.00 | 1 | |
| Indice | 1 | 1.00 | 0.99 | 0.99 | 1.00 | 1.00 | 0.98 | 1.00 | 0.98 | 0.00 | 1.00 | 1.00 | 1.00 | 0.00 | | 0.85 |
| 1.3 | plan | 0;.27;.96;39.8 | 0.00 | 70.44 | 21.30 | 0.00 | 0.96 | -0.28 | -1.00 | 0.00 | 0.00 | 0.00 | 0.28 | 0.96 | | |
| 2.3 | plan | 0,0.164,0.986;27.948 | 0.00 | 50.15 | 19.97 | 0.00 | 0.99 | -0.16 | -1.00 | 0.00 | 0.00 | 0.00 | 0.16 | 0.99 | 2 | |
| Indice | 1 | 0.00 | 1.00 | 0.50 | 0.96 | 1.00 | 0.98 | 0.91 | 1.00 | 1.00 | 1.00 | 1.00 | 0.94 | 0.99 | | 0.91 |
| 1.4 | plan | 0,0;1;20 | 0.00 | 120.00 | 20.00 | 1.00 | 0.00 | 0.00 | 0.00 | 1.00 | 0.00 | 0.00 | 0.00 | 1.00 | | |
| 2.4 | plan | 0,0;1;20 | 0.00 | 120.00 | 20.00 | 1.00 | 0.00 | 0.00 | 0.00 | 1. 00 | 0.00 | 0.00 | 0.00 | 1.00 | | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | 2 | 1.00 |
| 1.5 | Cyl_int | 0;0;0;0,0;1;20 | 0.00 | 0.00 | 15.00 | 1.00 | 0.00 | 0.00 | 0.00 | 1.00 | 0.00 | 0.00 | 0.00 | 1.00 | | |
| 2.5 | Cyl_int | 0;0;0;0;0;1;20 | 0.00 | 0.00 | 15.00 | 1.00 | 0.00 | 0.00 | 0.00 | 1.00 | 0.00 | 0.00 | 0.00 | 1.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.6 | Cyl_int | 0;120;0;0;0;1;10 | 0.00 | 120.00 | 10.00 | 1.00 | 0.00 | 0.00 | 0.00 | 1.00 | 0.00 | 0.00 | 0.00 | 1.00 | | |
| 2.6 | Cyl_int | 0;120;0;0;0;1;10 | 0.00 | 120.00 | 10.00 | 1.00 | 0.00 | 0.00 | 0.00 | 1.00 | 0.00 | 0.00 | 0.00 | 1.00 | 2 | |
| Indice | 1 | 1.00 | 1. 00 | 1.00 | 1.00 | 1.00 | 1.00 | 1.00 | 1.00 | 1. 00 | 1.00 | 1.00 | 1.00 | 1.00 | | 1.00 |
| 1.7 | Plan | 1;0;0;50 | 50.00 | -20.00 | 15.00 | 0.00 | 0.00 | 1.00 | 0.00 | 1. 00 | 0.00 | -1.00 | 0.00 | 0.00 | | |
| 2.7 | Plan | 1,0;0;50 | 50. 00 | -20.00 | 15.00 | 0.00 | 0.00 | 1.00 | 0.00 | 1.00 | 0.00 | -1.00 | 0.00 | 0.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.8 | Plan | 0;1;0;-10 | 40.00 | -10.00 | 15.00 | 0.00 | 0.00 | 1.00 | 1.00 | 0.00 | 0.00 | 0.00 | 1.00 | 0.00 | | |
| 2.8 | Plan | 0;1;0;-10 | 40.00 | -10.00 | 15.00 | 0.00 | 0.00 | 1.00 | 1.00 | 0.00 | 0.00 | 0.00 | 1.00 | 0.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.9 | Plan | 1;0;0;30 | 30.00 | -5.00 | 15.00 | 0.00 | 0.00 | 1.00 | 0.00 | 1.00 | 0.00 | -1.00 | 0.00 | 0.00 | | |
| 2.9 | Plan | 1;0;0;30 | 30.00 | -5.00 | 15.00 | 0.00 | 0.00 | 1.00 | 0.00 | 1.00 | 0.00 | -1.00 | 0.00 | 0.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.10 | Cyl_ext | 0;0;0;0;0;1;30 | 22.98 | 16.25 | 15.00 | -0.58 | 0.82 | 0.00 | 0.00 | 0.00 | -1.00 | -0.82 | -0.58 | 0.00 | | |
| 2.10 | Cyl_ext | 0;0;0;0;0;1;30 | -3.79 | 17.45 | 15.20 | 1.00 | -0.07 | 0.01 | -0.07 | -0.99 | -0.14 | 0.02 | 0.14 | -0.99 | 1 | |
| Indice | 1 | 1.00 | 0.79 | 0.99 | 0.99 | 0.00 | 0.4.1 | 0.99 | 0.97 | 0.51 | 0.57 | 0.55 | 0.64 | 0.51 | | 0.71 |
| 1.11 | Plan | 1;0;0;10 | 10.00 | 60.00 | 11.97 | 0.00 | 0.99 | -0.15 | 0.00 | -0.15 | -0.99 | -1.00 | 0.00 | 0.00 | | |
| 2.11 | Plan | 1;0;0;10 | 10.00 | 42.88 | 10.59 | 0.00 | 1.00 | -0.09 | 0.00 | -0.09 | -1.00 | -1.00 | 0.00 | 0.00 | z | |
| Indice | 1 | 1.00 | 1.00 | 0.92 | 0.95 | 1.00 | 1.00 | 0.95 | 1.00 | 0.97 | 1.00 | 1.00 | 1.00 | 1.00 | | 0.98 |
| 1.12 | Cyl_ext | 0;120;0;0;0;1;20 | 0.00 | 122.24 | 10.43 | 1.00 | 0.00 | 0.00 | 0.00 | -1.00 | 0.07 | 0.00 | -0.07 | -1.00 | | |
| 2.12 | Cyl_ext | 0;120;0;0;0;1;20 | 0.00 | 122.03 | 10.45 | 1.00 | 0.00 | 0.00 | 0.00 | -1.00 | 0.07 | 0.00 | -0.07 | -1.00 | 2 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.13 | Plan | 1;0;0;-10 | -10.00 | 60.00 | 11.97 | 0.00 | 0.99 | -0.15 | 0.00 | -0.15 | -0.99 | -1.00 | 0.00 | 0.00 | | |
| 2.13 | Plan | 1;0;0;-10 | -10.00 | 42.88 | 10.59 | 0.00 | 1.00 | -0.09 | 0.00 | -0.09 | -1.00 | -1.00 | 0.00 | 0.00 | 2 | |
| Indice | 1 | 1.00 | 1.00 | 0.92 | 0.95 | 1.00 | 1.00 | 0.95 | 1.00 | 0.97 | 1.00 | 1.00 | 1.00 | 1.00 | | 0.98- |
| 1.14 | Cyl_ext | 0;0;0;0;0;1;30 | -22.98 | 16.25 | 15.00 | 0.58 | 0.82 | 0.00 | 0.00 | 0.00 | -1.00 | -0.82 | 0.58 | 0.00 | | |
| 2.10 | Cyl_ext | 0;0;0;0;0;1;30 | -3.79 | 17.45 | 15.20 | 1.00 | -0.07 | 0.01 | -0.07 | -0.99 | -0.14 | 0.02 | 0.14 | -0.99 | 1 | |
| Indice | 1 | 1.00 | 0.85 | 0.99 | 0.99 | 0.73 | 0.41 | 0.99 | 0.97 | 0.51 | 0.57 | 0.55 | 0.78 | 0.51 | | 0.78 |
| 1.15 | Plan | 1;0;0;-30 | -30.00 | -5.00 | 15.00 | 0.00 | 0.00 | 1.00 | 0.00 | 1.00 | 0.00 | -1.00 | 0.00 | 0.00 | | |
| 2.15 | Plan | 1;0;0;-30 | -30.00 | -5.00 | 15.00 | 0.00 | 0.00 | 1.00 | 0.00 | 1.00 | 0.00 | -1.00 | 0.00 | 0.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.16 | Plan | 0;1;0;-10 | -40.00 | -10.00 | 15.00 | 0.00 | 0.00 | 1.00 | 1.00 | 0.00 | 0.00 | 0.00 | 1.00 | 0.00 | | |
| 2.16 | Plan | 0;1;0;-10 | -40.00 | -10.00 | 15.00 | 0.00 | 0.00 | 1.00 | 1.00 | 0.00 | 0.00 | 0.00 | 1.00 | 0.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |
| 1.18 | Plan | 0;1;0;-30 | 0.00 | -30.00 | 15.00 | 1.00 | 0.00 | 0.00 | 0.00 | 0.00 | 1.00 | 0.00 | -1.00 | 0.00 | | |
| 2.18 | Plan | 0;1;0;-30 | 0.00 | -30.00 | 15.00 | 1.00 | 0.00 | 0.00 | 0.00 | 0.00 | 1.00 | 0.00 | -1.00 | 0.00 | 1 | |
| Indice | 1 | 1.00 | 1.00 | 1.00 | 1.00 | 1.00 | 1.00 | 1.00 | 1.00 | 1.00 | 1.00 | 1.00 | 1.00 | 1.00 | | 1.00 |

**Tableau 5: Résultat nettoyé après appariement et réconciliation des modèles 3D(Pas final)**

| **Mod.3D** | **Type** | **Type_Par** | **Gx** | **Gy** | **Gz** | **A1x** | **A1y** | **A1z** | **A2x** | **A2y** | **A2z** | **A3x** | **A3y** | **A3z** | **Matrice** | **Indice** |
|---|---|---|---|---|---|---|---|---|---|---|---|---|---|---|---|---|
| 1 | Corps | 18 | 0.00 | 25.80 | 13. 60 | 0.00 | 1.00 | 0.04 | -1 00 | 0.00 | 0.00 | 0.00 | 0.04 | 1.00 | | |
| 2 | Corps | 19 | 20.129 | 30.57 | 13.002 | 0.5 | 0.87 | -0.04 | -0.88 | 0.5 | -0.01 | 0.01 | 0.04 | 0.99 | 1 | |
| Indice | 1 | 0.97 | 0.84 | 0.98 | 0.99 | 0.68 | 0.91 | 0.93 | 0.94 | 0.75 | 1.00 | 0.99 | 1 00 | 1.00 | | 0.93 |
| 2 | Corps | 19 | 2.147 | 6.539 | 13.002 | 0.00 | 1.00 | -0.04 | -1 00 | 0.00 | -0.01 | -0.01 | 0.04 | 0.99 | 2 | |
| Indice | 1 | 0.97 | 0.98 | 0.91 | 0.98 | 1.00 | 1.00 | 0.94 | 1 00 | 1.00 | 1.00 | 1 00 | 1.00 | 1.00 | | 0.98 |
| 1.1 | Plan | 0;0;1;0 | 0.00 | 35.33 | 0.00 | 0.00 | 1.00 | 0.00 | 1 00 | 0.00 | 0.00 | 0.00 | 0.00 | -1.00 | | |
| 2.1 | Plan | 0;0;1;0 | 26.53 | 4159 | 0.00 | 0.49 | 0.87 | 0.00 | -0.87 | 0.49 | 0.00 | 0.00 | 0.00 | 1.00 | 1 | |
| Indice | 1 | 1.00 | 0.79 | 0.97 | 1.00 | 0.69 | 0.91 | 100 | 0.06 | 0.75 | 1.00 | 1 00 | 1 00 | 0.00 | | 0.80 |
| 2.1 | Plan | 0;0;1;0 | 218 | 19.29 | 0.00 | -0.01 | 1.00 | 0.00 | -1 00 | -0.01 | 0.00 | 0.00 | 0.00 | 1.00 | 2 | |
| Indice | 1 | 1.00 | 0.98 | 0.92 | 1.00 | 0.99 | 1.00 | 100 | 0.00 | 1.00 | 1.00 | 1 00 | 1 00 | 0.00 | | 0.85 |
| 1.2 | Plan | 0;0;1;30 | 0.00 | -5.95 | 30.00 | 1.00 | 0.00 | 0.00 | 0.00 | 1.00 | 0.00 | 0.00 | 0.00 | 1.00 | | |
| 2.2 | Plan | 0;0;1;30 | -117 | -8.75 | 30.00 | 1.00 | 0.03 | 0.00 | 0.03 | -1.00 | 0.00 | 0.00 | 0.00 | -1.00 | 1 | |
| Indice | 1 | 1.00 | 0.99 | 0.99 | 1.00 | 1.00 | 0.98 | 100 | 0.99 | 0.00 | 1.00 | 1 00 | 1 00 | 0.00 | | 0.85 |
| 2.2 | Plan | 0;0;1;30 | 3.36 | -38.16 | 30.00 | 0.85 | 0.53 | 0.00 | 0.53 | -0.85 | 0.00 | 0.00 | 0.00 | -1.00 | 2 | |
| Indice | 1 | 1.00 | 0.97 | 0.84 | 1.00 | 0.90 | 0.65 | 100 | 0.74 | 0.07 | 1.00 | 1 00 | 1 00 | 0.00 | | 0.80 |
| 1.3 | plan | 0;.27;.96;39.8 | 0.00 | 70.44 | 21.30 | 0.00 | 0.96 | -0.28 | -1 00 | 0.00 | 0.00 | 0.00 | 0.28 | 0.96 | | |
| 2.3 | plan | 0.08;0.14;0.98;32 88 | 40.08 | 69.42 | 19.97 | 0.49 | 0.85 | -0.16 | -0.87 | 0.50 | 0.00 | 0.08 | 0.14 | 0.99 | 1 | |
| Indice | 1 | 0.00 | 0.68 | 0.99 | 0.96 | 0.69 | 0.93 | 0.91 | 0.93 | 0.75 | 1.00 | 0.96 | 0.93 | 0.99 | | 0.84 |
| 2.3 | plan | 0;0.164;0.986;27.948 | 0.00 | 50.15 | 1997 | 0.00 | 0.99 | -0.16 | -1 00 | 0.00 | 0.00 | 0.00 | 0.16 | 0.99 | 2 | |
| Indice | 1 | 0.00 | 100 | 0.90 | 0.96 | 1.00 | 0.98 | 0.91 | 1 00 | 1.00 | 1.00 | 100 | 0.94 | 0.99 | | 0.91 |
| 1.4 | plan | 0;0;1;20 | 0.00 | 120.00 | 20.00 | 1.00 | 0.00 | 0.00 | 0.00 | 1.00 | 0.00 | 0.00 | 0.00 | 1.00 | | |
| 2.4 | plan | 0;0;1;20 | 75.00 | 129.90 | 20.00 | 1.00 | 0.00 | 0.00 | 0.00 | 1.00 | 0.00 | 0.00 | 0.00 | 1.00 | 1 | |
| Indice | 1 | 1.00 | 0.40 | 0.95 | 1.00 | 1.00 | 1.00 | 100 | 1 00 | 1.00 | 1.00 | 1 00 | 1 00 | 1.00 | | 0.95 |
| 2.4 | plan | 0;0;1;20 | 0.00 | 120.00 | 20.00 | 1.00 | 0.00 | 0.00 | 0.00 | 1.00 | 0.00 | 0.00 | 0.00 | 1.00 | | |
| Indice | 1 | 1.00 | 100 | 100 | 1.00 | 1.00 | 1.00 | 100 | 1 00 | 1.00 | 1.00 | 1 00 | 1 00 | 1.00 | 2 | 1.00 |
| 1.5 | Cyl_int | 0;0;0;0;0;1;20 | 0.00 | 0.00 | 15.00 | 1.00 | 0.00 | 0.00 | 0.00 | 1.00 | 0.00 | 0.00 | 0.00 | 1.00 | | |
| 2.5 | Cyl_int | 0;0;0;0;0;1;20 | 0.00 | 0.00 | 15.00 | 1.00 | 0.00 | 0.00 | 0.00 | 1.00 | 0.00 | 0.00 | 0.00 | 1.00 | 1 | |
| Indice | 1 | 1.00 | 100 | 100 | 1.00 | 1.00 | 1.00 | 100 | 1 00 | 1.00 | 1.00 | 1 00 | 1 00 | 1.00 | | 1.00 |
| 2.5 | Cyl_int | 0;-30;0;0;0;1;20 | 0.00 | -30.00 | 15.00 | 1.00 | 0.00 | 0.00 | 0.00 | 1.00 | 0.00 | 0.00 | 0.00 | 1.00 | 1 | |
| Indice | 1 | 0.86 | 100 | 0.85 | 1.00 | 1.00 | 1.00 | 100 | 1 00 | 1.00 | 1.00 | 1 00 | 1 00 | 1.00 | | 0.98 |
| 1.6 | Cyl_int | 0;120;0;0;0;1;10 | 0.00 | 120.00 | 10.00 | 1.00 | 0.00 | 0.00 | 0.00 | 1.00 | 0.00 | 0.00 | 0.00 | 1.00 | | |
| 2.6 | cyl_int | 75;129,9;0;0;0;1;10 | 75.00 | 129.90 | 10.00 | 1.00 | 0.00 | 0.00 | 0.00 | 1.00 | 0.00 | 0.00 | 0.00 | 1.00 | 1 | |
| Indice | 1 | 0.57 | 0.40 | 0.95 | 1.00 | 1.00 | 1.00 | 100 | 1 00 | 1.00 | 1.00 | 1 00 | 1 00 | 1.00 | | 0.92 |
| 2.6 | Cyl_int | 0;120;0;0;01;10 | 0.00 | 120.00 | 10.00 | 1.00 | 0.00 | 0.00 | 0.00 | 1.00 | 0.00 | 0.00 | 0.00 | 1.00 | 2 | |
| Indice | 1 | 1.00 | 100 | 100 | 1.00 | 1.00 | 1.00 | 100 | 1 00 | 1.00 | 1.00 | 100 | 1 00 | 1.00 | | 1.00 |
| 1.7 | Plan | 1;0;0;50 | 50.00 | -20.00 | 15.00 | 0.00 | 0.00 | 100 | 0.00 | 1.00 | 0.00 | -100 | 0.00 | 0.00 | | |
| 2.7 | Plan | 1;0;0;50 | 50.00 | -20.00 | 15.00 | 0.00 | 0.00 | 100 | 0.00 | 1.00 | 0.00 | -100 | 0.00 | 0.00 | 1 | |
| Indice | 1 | 1.00 | 100 | 100 | 1.00 | 1.00 | 1.00 | 100 | 1 00 | 1.00 | 1.00 | 100 | 1 00 | 1.00 | | 1.00 |
| 2.8 | Plan | 0;1;0;10 | 40.00 | -10.00 | 15. 00 | 0.00 | 0.00 | 100 | 1 00 | 0.00 | 0.00 | 0.00 | 1 00 | 0.00 | 1 | |
| Indice | 1 | 0.50 | 0.92 | 0.95 | 1.00 | 1.00 | 1.00 | 100 | 0.50 | 0.50 | 1.00 | 0.46 | 0.50 | 1.00 | | 0.81 |
| 2.15 | Plan | 0.866;0.5;0;-45 | -23.48 | -49.33 | 15.00 | 0.00 | 0.00 | 100 | 0.50 | -0.87 | 0.00 | 0.87 | 0.50 | 0.00 | 2 | |
| Indice | 1 | 0. 00 | 0.50 | 0.81 | 1.00 | 1.00 | 1.00 | 100 | 0.75 | 0.57 | 1.00 | 0.54 | D. 75 | 1.00 | | 0.78 |
| 2.16 | Plan | -0.5;0.866;0;-35.98 | -29.64 | -58.66 | 15.00 | 0.00 | 0.00 | 100 | -0.87 | -0.50 | 0.00 | D.5D | -0.87 | 0.00 | 2 | |
| Indice | 1 | 0.00 | 0.45 | 0.76 | 1.00 | 1.00 | 1.00 | 100 | 0.07 | 0.75 | 1.00 | 0.73 | 0.07 | 1.00 | | 0.70 |
| 1.9 | Plan | 1;0;0;30 | 30.00 | -5.00 | 15.00 | 0.00 | 0.00 | 100 | 0.00 | 1.00 | 0.00 | -100 | 0.00 | 0.00 | | |
| 2.9 | Plan | 1;0;0;30 | 30.00 | -5.00 | 15.00 | 0.00 | 0.00 | 100 | 0.00 | 1.00 | 0.00 | -100 | 0.00 | 0.00 | 1 | |
| Indice | 1 | 1.00 | 100 | 100 | 1.00 | 1.00 | 1.00 | 100 | 100 | 1.00 | 1.00 | 100 | 100 | 1.00 | | 1.00 |
| 2.15 | Plan | 1;0;0;-30 | -30.00 | -5.00 | 15.00 | 0.00 | 0.00 | 100 | 0.00 | 1.00 | 0.00 | -100 | 0.00 | 0.00 | 1 | |
| Indice | 1 | 0.75 | 0.52 | 100 | 1.00 | 1.00 | 1.00 | 100 | 100 | 1.00 | 1.00 | 100 | 100 | 1.00 | | 0.55 |
| 2.9 | Plan | 0.866;0.5;0;15 | 28.48 | -19.33 | 15. 00 | 0.00 | 0.00 | 100 | 0.50 | -0.87 | 0. 00 | 0.87 | 0.50 | 0.00 | 2 | |
| Indice | 1 | 0.00 | 0.99 | 0.93 | 1.00 | 1.00 | 1.00 | 100 | 0.75 | 0.07 | 1.00 | 0.00 | 0.75 | 1.00 | | 0.75 |
| 2.15 | Plan | 0.866;0.5;0;-45 | -23.48 | -49.33 | 15.00 | 0.00 | 0.00 | 100 | 0.50 | -0.87 | 0.00 | 0.87 | 0.50 | 0.00 | 2 | |
| Indice | 1 | 0.00 | 0.58 | 0.75 | 1.00 | 1.00 | 1.00 | 100 | 0.75 | 0.07 | 1.00 | 0.00 | 0.75 | 1.00 | | 0.71 |
| 1.10 | Cyl_ext | 0;0;0;0;0;1;30 | 2298 | 16.25 | 15.00 | -0.58 | 0.82 | 0.00 | 0. 00 | 0.00 | -1.00 | -0.82 | -0.58 | 0.00 | | |
| 2.10 | Cyl_ext | 0;0;0;0;0;1;30 | -3.79 | 17.45 | 15.20 | 1.00 | -0.07 | 0.01 | -0.07 | -0.99 | -0.14 | 0.02 | 0.14 | -0.99 | 1 | |
| Indice | 1 | 1.00 | 0.79 | 0.99 | 0.99 | 0.00 | 0.41 | 0.99 | 0.97 | 0.51 | 0.57 | 0.55 | 0.64 | 0.51 | | 0.71 |
| 2.10 | Cyl_ext | 0;-30;0;0;0;1;30 | -1201 | -16.78 | 15. 20 | 0.90 | 0.44 | 0.01 | 0.54 | -0.89 | -0.14 | -0.05 | 0.13 | -0.59 | 2 | |
| Indice | 1 | 0.75 | 0.72 | 0.84 | 0.99 | 0.07 | 0.75 | 0.99 | 0.73 | 0.56 | 0.57 | 0.59 | 0.65 | 0.51 | | 0.69 |
| 1.11 | Plan | 1;0;0;10 | 10.00 | 60.00 | 11 97 | 0.00 | 0.99 | -0.15 | 0.00 | -0.15 | -0.99 | -100 | 0.00 | 0.00 | | |
| 2.11 | Plan | 0.866;-0.5;0;10 | 45.10 | 5812 | 10.59 | 0.50 | 0.86 | -0.09 | -0.04 | -0.08 | -1.00 | -0.87 | 0.50 | 0.00 | 1 | |
| Indice | 1 | 0.25 | 0.72 | 0.99 | 0.95 | 0.68 | 0.92 | 0.95 | 0.58 | 0.96 | 1.00 | 0.93 | 0.75 | 1.00 | | 0.86 |
| 2..13 | Plan | 0.866;-0.5;0;-10 | 27.78 | 68.12 | 10.59 | 0.50 | 0.86 | -0.09 | -0.04 | -0.08 | -1.00 | -0.87 | 0.50 | 0.00 | 1 | |
| Indice | 1 | 0.00 | 0.86 | 0.95 | 0.95 | 0.68 | 0.92 | 0.95 | 0.98 | 0.96 | 1.00 | 0.93 | 0.75 | 1.00 | | 0.85 |
| 2.11 | Plan | 1;0;0;10 | 10.00 | 4288 | 10.59 | 0.00 | 1.00 | -0.09 | 0.00 | -0.08 | -1.00 | -100 | 0.00 | 0.00 | 2 | |
| Indice | 1 | 1.00 | 100 | 0.92 | 0.95 | 1.00 | 1.00 | 0.95 | 1 00 | 0.97 | 1.00 | 100 | 100 | 1.00 | | 0.98 |
| 2..13 | Plan | 1;0;0;-10 | -10.00 | 4288 | 10.59 | 0.00 | 1.00 | -0.09 | 0.20 | -0.09 | -1.00 | -1 00 | 0.00 | 0.00 | 2 | |
| Indice | 1 | 0.75 | 0.84 | 0.92 | 0.95 | 1.00 | 1.00 | 0.95 | 100 | 0.97 | 1.00 | 100 | 100 | 1.00 | | 0.96 |
| 1.12 | Cyl_ext | 0;120;0;0;0;1,20 2D | 0.00 | 122 24 | 10.43 | 1.00 | 0.00 | 0.00 | 0.00 | -1.00 | 0.07 | 0.00 | -0.07 | -1.00 | | |
| 2.12 | Cyl_ext | 75;129.9;0;0;0;1;20 | 76.01 | 13166 | 10.45 | 0.97 | -0.50 | 0.00 | -0.50 | -0.86 | 0.07 | -0.03 | -0.06 | -1.00 | 1 | |
| Indice | 1 | 0.25 | 0.40 | 0.95 | 1.00 | 0.92 | 0.67 | 100 | 0.75 | 0.93 | 1.00 | 0.98 | 100 | 1.00 | | 0.85 |
| 2.12 | Cyl_ext | 0;120;0;0;01;20 | 0.00 | 12203 | 10.45 | 1.00 | 0.00 | 0.00 | 0.00 | -1.00 | 0.07 | 0.00 | -0.07 | -1.00 | 2 | |
| Indice | 1 | 1.00 | 100 | 100 | 1.00 | 1.00 | 1.00 | 100 | 100 | 1.00 | 1.00 | 100 | 100 | 1.00 | | 1.00 |
| 1.13 | Plan | 1:0;0;-10 | -10.00 | 60.00 | 11 97 | 0.00 | 0.99 | -0.15 | 0.00 | -0.15 | -0.99 | -100 | 0.00 | 0.00 | | |
| 2..11 | Plan | 0.866;-0.5;0;10 | 45.10 | 5812 | 10.59 | 0.50 | 0.86 | -0.09 | -0.04 | -0.08 | -1.00 | -0.87 | 0.50 | 0.00 | 1 | |
| Indice | 1 | 0.50 | 0.56 | 0.99 | 0.95 | 0.68 | 0.92 | 0.95 | 0.98 | 0.96 | 1.00 | 0.93 | 0.75 | 1.00 | | 0.87 |
| 2.13 | Plan | 0.866;-0.5;0;-10 | 27.78 | 6812 | 10.59 | 0.50 | 0.86 | -0.09 | -0.04 | -0.08 | -1.00 | -0.87 | 0.50 | 0.00 | 1 | |
| Indice | 1 | 0.50 | 0.70 | 0.96 | 0.95 | 0.69 | 0.92 | 0.95 | 0.58 | 0.96 | 1.00 | 0.93 | 0.75 | 1.00 | | 0.88 |
| 2.11 | Plan | 1;0;0;10 | 10.00 | 4288 | 10.59 | 0.00 | 1.00 | -0.09 | 0.00 | -0.09 | -1.00 | -100 | 0.00 | 0.00 | 2 | |
| Indice | 1 | 0.75 | 0.84 | 0.92 | 0.95 | 1.00 | 1.00 | 0.95 | 100 | 0.97 | 1.00 | 100 | 100 | 1.00 | | 0.56 |
| 2.13 | Plan | 1;0;0;-10 | -10.00 | 4288 | 10.59 | 0.00 | 1.00 | -0.09 | 0.00 | -0.08 | -1.00 | -100 | 0.00 | 0.00 | 2 | |
| Indice | 1 | 1.00 | 100 | 0.92 | 0.95 | 1.00 | 1.00 | 0.95 | 1 00 | 0.97 | 1.00 | 100 | 100 | 1.00 | | 0.98 |
| 1.14 | Cyl_ext | 0;0;0;0;0;1;30 | -22.98 | 16.25 | 15. 00 | 0.58 | 0.82 | 0.00 | 0.00 | 0.00 | -1.00 | -0.B2 | 0.58 | 0.00 | | |
| 2.10 | Cyl_ext | 0;0;0;0;0;1;30 | -3.79 | 17.45 | 15. 20 | 1.00 | -0.07 | 0.01 | -0.07 | -0.99 | -0.14 | 0.02 | 0.14 | -0.99 | 1 | |
| Indice | 1 | 1.00 | 0.85 | 0.99 | 0.99 | 0.73 | 0.41 | 0.99 | 0.97 | 0.51 | 0.57 | 0.55 | 0.78 | 0.51 | | 0.78 |
| 2.1D | Cyl_ext | 0;-30;0;0;1;30 | -12.01 | -16.78 | 15.20 | 0.90 | 0.44 | 0.01 | 0.54 | -0.89 | -0.14 | -0.05 | 0.13 | -0.99 | 2 | |
| Indice | 1 | 0.75 | 0.91 | 0.84 | 0.99 | 0.80 | 0.75 | 0.99 | 0.73 | 0.56 | 0.57 | 0.59 | 0.78 | 0.51 | | 0.*77* |
| 1.15 | Plan | 1;0;0;-30 | -30.00 | -5.00 | 15.00 | 0.00 | 0.00 | 1.00 | 0.00 | 1.00 | 0.00 | -100 | 0.00 | 0.00 | | |
| 2.9 | Plan | 1;0;0;30 | 30.00 | -5.00 | 15.00 | 0.00 | 0.00 | 1.00 | 0.00 | 1.00 | 0.00 | -100 | 0.00 | 0.00 | 1 | |
| Indice | 1 | 0.75 | 0.52 | 100 | 1.00 | 1.00 | 1.00 | 1.00 | 100 | 1.00 | 1.00 | 100 | 100 | 1.00 | | 0.95 |
| 2.15 | Plan | 1;0;0;-30 | -30.00 | -5.00 | 15.00 | 0.00 | 0.00 | 1.00 | 0.00 | 1.00 | 0.00 | -100 | 0.00 | 0.00 | 1 | |
| Indice | 1 | 1.00 | 100 | 100 | 1.00 | 1.00 | 1.00 | 1.00 | 100 | 1.00 | 1.00 | 1.00 | 1.00 | 1.00 | | 1.00 |
| 2.9 | Plan | 0.866;0.5;0;15 | 28.48 | -19.33 | 15.00 | 0.00 | 0.00 | 1.00 | 0.50 | -0.87 | 0.00 | 0.87 | 0.50 | 0.00 | 2 | |
| Indice | 1 | 0.25 | 0.54 | 0.93 | 1.00 | 1.00 | 1.00 | 1.00 | 0.75 | 0.07 | 1.00 | 0.00 | 0.75 | 1.00 | | 0.73 |
| 2.15 | Plan | 0.866;0.5;0;-45 | -23.48 | -49.33 | 15. 00 | 0.00 | 0.00 | 1.00 | 0.50 | -0.87 | 0.00 | 0.87 | 0.50 | 0.00 | 2 | |
| Indice | 1 | 0.25 | 0.95 | 0.78 | 1.00 | 1.00 | 1.00 | 1.00 | 0.75 | 0.07 | 1.00 | 0.00 | 0.75 | 1.00 | | 0.75 |
| 1.16 | Plan | 0;1;0;-10 | -40.00 | -10.00 | 15.00 | 0.00 | 0.00 | 1.00 | 100 | 0.00 | 0.00 | 0.00 | 100 | 0.00 | | |
| 2.7 | Plan | 1;0;0;50 | 50.00 | -20.00 | 15.00 | 0.00 | 0.00 | 1.00 | 0.00 | 1.00 | 0.00 | -100 | 0.00 | 0.00 | 1 | |
| Indice | 1 | 0.25 | 0.29 | 0.95 | 1.00 | 1.00 | 1.00 | 1.00 | 0.50 | 0.50 | 1.00 | 0.46 | 0.50 | 1.00 | | D. 75 |
| 2.8 | Plan | 0;1;0;-10 | 40.00 | -10.00 | 15.00 | 0.00 | 0.00 | 1.00 | 100 | 0.00 | 0.00 | 0.00 | 100 | 0.00 | 1 | |
| Indice | 1 | 1.00 | 0.37 | 100 | 1.00 | 1.00 | 1.00 | 1.00 | 100 | 1.00 | 1.00 | 100 | 100 | 1.00 | | 0.95 |
| 2.16 | Plan | 0;1;0;-10 | -40.00 | -10.00 | 15.00 | 0.00 | 0.00 | 1.00 | 100 | 0.00 | 0.00 | 0.00 | 100 | 0.00 | 1 | |
| Indice | 1 | 1. 00 | 100 | 100 | 1.00 | 1.00 | 1.00 | 1.00 | 100 | 1.00 | 1.00 | 100 | 100 | 1.00 | | 1.00 |
| 2.17 | Plan | 1;0;0;-50 | -50.00 | -20.00 | 15.00 | 0.00 | 0.00 | 1.00 | 0.00 | 1.00 | 0.00 | -100 | 0.00 | 0.00 | 1 | |
| Indice | 1 | 0.75 | 0.92 | 0.95 | 1.00 | 1.00 | 1.00 | 1.00 | 0.50 | 0.50 | 1.00 | 0.46 | 0.50 | 1.00 | | 0.83 |
| 2.7 | Plan | 1;0;0;50 | 50.00 | -20.00 | 15.00 | 0.00 | 0.00 | 1.00 | 0.00 | 1.00 | 0.00 | -100 | 0.00 | 0.00 | 2 | |
| Indice | 1 | 0.25 | 0.29 | 0.95 | 1.00 | 1.00 | 1.00 | 1.00 | 0.50 | 0.50 | 1.00 | 0.46 | 0.50 | 1.00 | | 0.75 |
| 2.8 | Plan | 0;1;0;-10 | 40.00 | -10.00 | 15.00 | 0.00 | 0.00 | 1.00 | 100 | 0.00 | 0.00 | 0.00 | 100 | 0.00 | 2 | |
| Indice | 1 | 1.00 | 0.27 | 100 | 1.00 | 1.00 | 1.00 | 1.00 | 100 | 1.00 | 1.00 | 100 | 100 | 1.00 | | 0.95 |
| 2.16 | Plan | -0.5;0.866;0;-35.98 | -29.64 | -58.66 | 15.00 | 0.00 | 0.00 | 1.00 | -0.87 | -0.50 | 0.00 | 0.50 | -0.87 | 0.00 | 2 | |
| Indice | 1 | 0.25 | 0.92 | 0.76 | 1.00 | 1.00 | 1.00 | 1.00 | 0.07 | 0.75 | 1.00 | 0.73 | 0.07 | 1.00 | | D. 75 |
| 2.17 | Plan | 0.866;0.5;0;-6.5 | -33.30 | -72.32 | 15.00 | 0.00 | 0.00 | 1.00 | 0.50 | -0.87 | 0.00 | 0.87 | 0.50 | 0.00 | 2 | |
| Indice | 1 | 0.25 | 0.95 | 0.69 | 1.00 | 1.00 | 1.00 | 1.00 | 0.75 | 0.57 | 1.00 | 0.54 | 0.75 | 1.00 | | 0.82 |
| 1.18 | Plan | 0;1;0;-30 | 0.00 | -30.00 | 15.00 | 1.00 | 0.00 | 0.00 | 0.00 | 0.00 | 1.00 | 0.00 | -100 | 0.00 | | |
| 2.18 | Plan | 0;1;0;-30 | 0.00 | -30.00 | 15.00 | 1.00 | 0.00 | 0.00 | 0.00 | 0.00 | 1.00 | 0.00 | -100 | 0.00 | 1 | |
| Indice | 1 | 1.00 | 100 | 100 | 1.00 | 1.00 | 1.00 | 1.00 | 100 | 1.00 | 1.00 | 100 | 100 | 1.00 | | 1.00 |
| 2.18 | Plan | -0.5;0.865;0;-55.98 | 15.00 | -55.98 | 15.00 | 0.87 | 0.50 | 0.00 | 0.00 | 0.00 | -1.00 | -0.50 | 0.87 | 0.00 | 2 | |
| Indice | 1 | 0.25 | 0.88 | 0.87 | 1.00 | 0.92 | 0.67 | 1.00 | 100 | 1.00 | 0.00 | 0.73 | 0.07 | 1.00 | | 0.74 |

## Revendications

1. Un procédé de comparaison, réalisé par un système informatique, entre un modèle 3D de référence et un modèle 3D cible aux fins d'une analyse comparative de modèles 3D, le procédé comprenant:
associer à chacun des modèles 3D au moins un descripteur chargé dans une base de données, l'au moins un descripteur comprenant des caractéristiques géométriques associées qui sont invariables en fonction du repère de modélisation et des caractéristiques géométriques associées qui dépendent du repère;
pour les caractéristiques géométriques associées qui sont invariables en fonction du repère, utiliser des moyens de traitement associés à la base de données pour apparier les parties du modèle 3D de référence et les parties du modèle 3D cible;
pour les caractéristiques géométriques associées qui dépendent du repère pour au moins les parties dont l'appariement est réussi selon une marge d'erreur acceptable, utiliser les moyens de traitement pour déterminer des groupes de transformations associant les parties du modèle 3D de référence et les parties du modèle 3D cible;
utiliser les moyens de traitement pour déterminer au moins un groupe de transformations similaires; et
utiliser les moyens de traitement pour afficher à l'utilisateur des ressemblances et des différences entre le modèle 3D de référence et le modèle 3D cible qui sont identifiées, au moins en partie, en utilisant ledit au moins un groupe de transformations similaires afin de permettre à l'utilisateur de mieux comparer le modèle 3D de référence au modèle 3D cible.

2. Le procédé selon la revendication 1, dans lequel les caractéristiques géométriques associées qui sont invariables en fonction du repère de modélisation comprennent la superficie et/ou le périmètre des faces planes de modèle, et des caractéristiques géométriques associées qui dépendent du repère de modélisation comprennent le centre de gravité et/ou les axes des moments d'inertie des faces planes.

3. Le procédé selon la revendication 1 ou 2, dans lequel l'étape de déterminer au moins un groupe de transformations similaires comprend déterminer au moins deux groupes de transformations similaires afin de permettre la comparaison des modèles 3D similaires, où au moins une partie du modèle 3D de référence est dans une position différente par rapport à une partie correspondante du modèle 3D cible.

4. Le procédé selon la revendication 3, dans lequel les différences entre les modèles 3D sont identifiées, au moins en partie, par les au moins deux groupes de transformations similaires.

5. Le procédé selon l'une quelconque des revendications 1 à 4, dans lequel on compare l'au moins un descripteur du modèle 3D de référence à l'au moins un descripteur du modèle 3D cible, et l'étape d'utiliser des caractéristiques géométriques associées qui sont invariables en fonction du repère pour apparier les parties du modèle 3D de référence et les parties du modèle 3D cible se fait pour l'au moins un descripteur du modèle 3D cible afin de prioriser ou de limiter l'étape d'utiliser des caractéristiques géométriques associées qui dépendent du repère selon l'appariement du au moins un descripteur.

6. Le procédé selon l'une quelconque des revendications 1 à 5, dans lequel des données d'appariement et des groupes de transformations sont stockées afin de faciliter des comparaisons plus ciblées ou des comparaisons ultérieures.

7. Le procédé selon l'une quelconque des revendications 1 à 6, dans lequel on compare l'au moins un descripteur du modèle 3D de référence à l'au moins un descripteur du modèle 3D cible, et on présente des résultats de comparaison regroupés selon l'appariement et selon les groupes de transformations.

8. Le procédé selon l'une quelconque des revendications 1 à 7, dans lequel on présente le modèle 3D de référence comparé au modèle 3D cible avec des faces coloriées ou hachurées afin d'identifier les ressemblances et les différences entre modèles 3D.

9. Le procédé selon la revendication 8, dans lequel on présente au moins deux ressemblances et/ou différences de caractéristiques géométriques reliées à la même face correspondante entre ces deux modèles 3D.

10. Un système de traitement de données configuré à réaliser le procédé de comparaison des modèles 3D aux fins d'une recherche, d'un classement ou d'une analyse comparative de modèles 3D selon l'une quelconque des revendications précédentes.

11. Un procédé de fabrication d'un produit comprenant au moins une pièce, le procédé comprenant :
une étape de sélection d'un modèle 3D cible en fonction desdites ressemblances et desdites différences identifiées en réalisant le procédé de comparaison selon l'une quelconque des revendications 1 à 9; et
une étape de fabrication de ladite pièce à partir dudit modèle 3D cible.

## Patentansprüche

1. Verfahren zum Vergleichen, das durch ein Computersystem durchgeführt wird, zwischen einem 3D-Referenzmodell und einem 3D-Zielmodell zum Zweck einer Vergleichsanalyse von 3D-Modellen, das Verfahren umfassend:
Zuordnen zu jedem der 3D-Modelle mindestens eines Deskriptors, der in einer Datenbank geladen ist, wobei der mindestens eine Deskriptor zugeordnete geometrische Merkmale, die im Zusammenhang mit dem Modellierungskoordinatensystem unveränderlich sind, und zugeordnete geometrische Merkmale, die von dem Koordinatensystem abhängen, umfasst;
für die zugeordneten geometrischen Merkmale, die im Zusammenhang mit dem Koordinatensystem unveränderlich sind, Verwenden von Verarbeitungsmitteln, die der Datenbank zugeordnet sind, zum paarweisen Zusammentun der Teile des 3D-Referenzmodells und der Teile des 3D-Zielmodells;
für die zugeordneten geometrischen Merkmale, die von dem Koordinatensystem für mindestens die Teile abhängen, deren Paarung gemäß einer akzeptablen Fehlermarge erfolgreich ist, Verwenden der Verarbeitungsmittel zum Bestimmen von Transformationsgruppen, die die Teile des 3D-Referenzmodells und die Teile des 3D-Zielmodells zuordnen;
Verwenden der Verarbeitungsmittel zum Bestimmen mindestens einer Gruppe ähnlicher Transformationen; und
Verwenden der Verarbeitungsmittel zum Anzeigen für den Benutzer von Ähnlichkeiten und Unterschieden zwischen dem 3D-Referenzmodell und dem 3D-Zielmodell, die mindestens teilweise unter Verwendung der mindestens einen Gruppe ähnlicher Transformationen identifiziert werden, um dem Benutzer zu ermöglichen, das 3D-Referenzmodell besser mit dem 3D-Zielmodell zu vergleichen.

2. Verfahren nach Anspruch 1, wobei die zugeordneten geometrischen Merkmale, die im Zusammenhang mit dem Modellierungskoordinatensystem unveränderlich sind, die Oberfläche und/oder den Umfang von ebenen Modellflächen umfassen, und zugeordnete geometrische Merkmale, die von dem Modellierungskoordinatensystem abhängen, den Schwerpunkt und/oder die Achsen der Trägheitsmomente der ebenen Flächen umfassen.

3. Verfahren nach Anspruch 1 oder 2, wobei der Schritt des Bestimmens mindestens einer Gruppe ähnlicher Transformationen das Bestimmen mindestens zweier Gruppen ähnlicher Transformationen umfasst, um den Vergleich ähnlicher 3D-Modelle zu ermöglichen, wobei mindestens ein Teil des 3D-Referenzmodells in einer unterschiedlichen Position im Verhältnis zu einem entsprechenden Teil des 3D-Zielmodells ist.

4. Verfahren nach Anspruch 3, wobei die Unterschiede zwischen den 3D-Modellen mindestens teilweise durch die mindestens zwei Gruppen ähnlicher Transformationen identifiziert werden.

5. Verfahren nach einem der Ansprüche 1 bis 4, wobei mindestens ein Deskriptor des 3D-Referenzmodells mit mindestens einem Deskriptor des 3D-Zielmodells verglichen wird, und der Schritt des Verwendens von zugeordneten geometrischen Merkmalen, die im Zusammenhang mit dem Koordinatensystem unveränderlich sind, zum paarweisen Zusammentun der Teile des 3D-Referenzmodells und der Teile des 3D-Zielmodells, für mindestens einen Deskriptor des 3D-Zielmodells ausgeführt wird, um den Schritt des Verwendens von zugeordneten geometrischen Merkmalen, die von dem Koordinatensystem abhängen, gemäß der Paarung des mindestens einen Deskriptors zu priorisieren oder zu begrenzen.

6. Verfahren nach einem der Ansprüche 1 bis 5, wobei Paarungsdaten und Transformationsgruppen gespeichert werden, um gezieltere Vergleiche oder spätere Vergleiche zu erleichtern.

7. Verfahren nach einem der Ansprüche 1 bis 6, wobei der mindestens eine Deskriptor des 3D-Referenzmodells mit dem mindestens einen Deskriptor des 3D-Zielmodells verglichen wird und Vergleichsergebnisse dargestellt werden, die nach der Paarung und nach den Transformationsgruppen gruppiert sind.

8. Verfahren nach einem der Ansprüche 1 bis 7, wobei das 3D-Referenzmodell im Vergleich zu dem 3D-Zielmodell mit gefärbten oder schraffierten Flächen dargestellt wird, um die Ähnlichkeiten und Unterschiede zwischen den 3D-Modellen zu identifizieren.

9. Verfahren nach Anspruch 8, wobei mindestens zwei Ähnlichkeiten und/oder Unterschiede geometrischer Merkmale dargestellt werden, die mit derselben entsprechenden Fläche zwischen diesen zwei 3D-Modellen verbunden sind.

10. Datenverarbeitungssystem, das zum Durchführen des Verfahrens zum Vergleichen von 3D-Modellen zum Zweck einer Suche, einer Klassifizierung oder einer Vergleichsanalyse von 3D-Modellen nach einem der vorstehenden Ansprüche konfiguriert ist.

11. Verfahren zum Herstellen eines Produkts, das mindestens ein Stück umfasst, das Verfahren umfassend:
einen Schritt zum Auswählen eines 3D-Zielmodells im Zusammenhang mit den Ähnlichkeiten und den identifizierten Unterschieden durch Durchführung des Vergleichsverfahrens nach einem der Ansprüche 1 bis 9; und
einen Herstellungsschritt des Stücks ausgehend von dem 3D-Zielmodell.

## Claims

1. A comparison method, carried out by a computer system, between a reference 3D model and a target 3D model for the purpose of a comparative analysis of 3D models, the method comprising:
associating each of the 3D models with at least one descriptor stored in a database, said at least one descriptor comprising associated geometric characteristics that are invariant with respect to the modelling reference frame and associated geometric characteristics that are dependent on the reference frame;
for the associated geometric characteristics that are invariant with respect to the reference frame, using processing means associated with the database to match parts of the reference 3D model and parts of the target 3D model;
for the associated geometric characteristics that are dependent on the reference frame, for at least the parts for which matching is successful within an acceptable error margin, using the processing means to determine groups of transformations associating parts of the reference 3D model and parts of the target 3D model;
using the processing means to determine at least one group of similar transformations; and
using the processing means to display to the user similarities and differences between the reference 3D model and the target 3D model that are identified, at least in part, by using said at least one group of similar transformations in order to enable the user to better compare the reference 3D model with the target 3D model.

2. The method according to claim 1, wherein the associated geometric characteristics that are invariant with respect to the modelling reference frame comprise the surface area and/or the perimeter of planar faces of the model, and the associated geometric characteristics that are dependent on the modelling reference frame comprise the centre of gravity and/or the axes of moments of inertia of the planar faces.

3. The method according to claim 1 or 2, wherein the step of determining at least one group of similar transformations comprises determining at least two groups of similar transformations in order to enable comparison of similar 3D models, wherein at least one part of the reference 3D model is in a different position relative to a corresponding part of the target 3D model.

4. The method according to claim 3, wherein the differences between the 3D models are identified, at least in part, by the at least two groups of similar transformations.

5. The method according to any one of claims 1 to 4, wherein at least one descriptor of the reference 3D model is compared with at least one descriptor of the target 3D model, and the step of using the associated geometric characteristics that are invariant with respect to the reference frame to match the parts of the reference 3D model and the parts of the target 3D model is performed for said at least one descriptor of the target 3D model in order to prioritise or to limit the step of using the associated geometric characteristics that are dependent on the reference frame according to matching of said at least one descriptor.

6. The method according to any one of claims 1 to 5, wherein matching data and groups of transformations are stored in order to facilitate more targeted comparisons or subsequent comparisons.

7. The method according to any one of claims 1 to 6, wherein at least one descriptor of the reference 3D model is compared with at least one descriptor of the target 3D model, and comparison results grouped according to matching and according to the groups of transformations are presented.

8. The method according to any one of claims 1 to 7, wherein the reference 3D model compared with the target 3D model is presented with coloured or hatched faces in order to identify similarities and differences between the 3D models.

9. The method according to claim 8, wherein at least two similarities and/or differences of geometric characteristics related to the same corresponding face between these two 3D models are presented.

10. A data processing system configured to carry out the method of comparison of 3D models for the purposes of search, classification or comparative analysis of 3D models according to any one of the preceding claims.

11. A method for manufacturing a product comprising at least one part, the method comprising:
a step of selecting a target 3D model based on said similarities and said differences identified by carrying out the comparison method according to any one of claims 1 to 9; and
a step of manufacturing said part from said target 3D model.
